# EUROPEAN PATENT APPLICATION

(11) **EP 2 639 639 A2**
(43) Date of publication of application: **18.09.2013**
(21) Application number: 13000468.2
(22) Date of filing: 31.01.2013
(51) Int. Cl.: G03F 7/09, G03F 7/095

(54) **Method of manufacturing a semiconductor device**

(30) Priority: 13.03.2012 JP 2012055444
(71) Applicant: Hitachi Ltd., Tokyo 100-8280 (JP)
(72) Inventor: Kakuta, Kazuyuki, Tokyo 100-8220 (JP); Ando, Toshio, Tokyo 100-8220 (JP); Hiruma, Kenji, Tokyo 100-8220 (JP); Onozuka, Toshihiko, Tokyo 100-8220 (JP); Katsuyama, Kiyomi, Tokyo 100-8220 (JP); Satoh, Kiyohiko, Tokyo 100-8220 (JP); Iida, Yasushi, Tokyo 100-8220 (JP)
(74) Representative: Strehl Schübel-Hopf & Partner

(57) **Abstract**

After performing a pretreatment step of coating an organic solvent mixed with a polymeric organic compound over a substrate having a tungsten film formed on the surface of the substrate, a chemically amplified resist is coated to form a resist pattern. Further, a ratio of a C1s peak intensity to a W4d peak intensity measured by XPS is 0.1 or mote at the surface of the tungsten film after the pretreatment step and before coating the chemically amplified resist.

## Description

### FIELD OF THE INVENTION

The present invention concerns a method of manufacturing a semiconductor device, and it particularly relates to a method of manufacturing a semiconductor device including a step of forming a resist pattern by using a photolithographic technique.

### BACKGROUND OF THE INVENTION

In manufacturing processes for various semiconductor devices such as MEMS (Micro Electro Mechanical System), for example, supersonic sensors, or LSIs (Large Scale Integrated Circuits), a photolithographic technique and a dry etching technique are used as a method of forming a fine pattern on a semiconductor substrate. Among them, in the photolithographic technique, a semiconductor substrate is coated with a resist, and the semiconductor substrate coated with the resist is exposed repetitively by exposure light projected under reduction by way of a reduction projection optical system having a photomask, to transfer the pattern to the resist (mask pattern), and then a development treatment is applied to form a resist pattern over the semiconductor substrate.

Resolution R of a pattern transferred to a resist by exposure light projected under reduction by way of a reduction projection optical system is generally expressed as: R = k x λ/NA, in which k is a constant depending on the resist material or process, λ is a wavelength of exposure light, and NA is a numerical aperture of an exposure lens. As can be seen from the relation, as a pattern becomes finer (resolution R decreases), an aligner provided with a light source for radiation of exposure light having a shorter wavelength λ is required.

At present, production processes for various types of semiconductor devices have been performed by aligners provided with a light source for radiation of g-line (λ = 438 nm) or i-line (λ = 365 nm) of mercury lamps, KrF (krypton fluoride) excimer laser light (λ = 248 nm), ArF (argon fluoride) excimer laser light (λ = 193 nm), etc.

Further, as the wavelength λ of the exposure light becomes shorter, resist materials are also changed. For example, resists corresponding to exposure light of g-line, i-line, KrF excimer laser light, and ArF excimer laser light are referred to as g-lines resist, i-line resist, KrF resist, and ArF resist respectively. Among them, as the KrF resist, for example, a chemically amplified resist at a higher sensitivity than the usual resist is used since the intensity of the KrF excimer laser light is smaller than that of the g-line.

On the other hand, for forming a resist pattern at a high profile accuracy by the photolithographic technique, it is important to coat the semiconductor substrate with a resist at a good film thickness uniformity or improve the solubility of the resist to a developer in an exposed area. Japanese Unexamined Patent Application Publication No. 2005-230602 describes a technique of supplying a solvent for a coating material over the entire surface of a substrate, drying the same and then applying the coating material. Further, US Laid-Open No. 2003/0138735 describes a technique of surface treating the surface of an underlayer film containing a basic material by exposing the same in a plasma using a carbon-containing gas and forming a chemically amplified resist on the surface treated underlayer film.

### SUMMARY OF THE INVENTION

According to the study of the present inventors, the followings have been found.

An example of the MEMS described above includes a supersonic sensor provided with a capacitance type sensor cell having a lower electrode formed over the main surface of a semiconductor substrate and an upper electrode disposed over the lower electrode so as to oppose by way of a cavity. Further, such a supersonic sensor includes those in which an electrode such as the lower electrode or the upper electrode described above and interconnects connected with such electrodes comprise tungsten (W). In a case of manufacturing a semiconductor device comprising the MEMS described above, a tungsten film is formed over the main surface of the semiconductor substrate, a resist pattern is formed on the formed tungsten film using a photolithographic technique and fabricating the tungsten film by using the formed resist pattern as a mask using a dry etching technique thereby forming the electrodes or the interconnects.

When a resist pattern is formed on the tungsten film, after applying a KrF resist which is, for example, a chemically amplified resist on the tungsten film, the semiconductor substrate is exposed, for example, by exposure light comprising, for example, KrF excimer laser light and then the exposed semiconductor substrate is developed.

However, when a resist pattern comprising the chemically amplified resist is formed on the tungsten film, the formed resist pattern sometimes exfoliates after development. Particularly, it has been found that as the line width of the formed resist pattern, that is, the line width of the transferred mask pattern becomes finer, the resist pattern tends to exfoliates. Further, when the resist pattern tends to exfoliates, electrodes or interconnects comprising the tungsten film cannot be formed at a good profiling accuracy to lower the performance of a manufactured semiconductor device such as MEMS.

Te present invention intends to provide a technique capable of improving the performance of a semiconductor device.

The foregoing and other purposes, as well as novel features of the present invention will become apparent by reference to the description of the present specification and the appended drawings.

An outline of typical inventions among those disclosed in the present application is to be described simply as below.

In a method of manufacturing a semiconductor device according to a typical embodiment, after performing a pretreatment step of coating a substrate having a tungsten film formed on the surface with an organic solvent mixed with a polymeric organic compound, the substrate is coated with a chemically amplified resist to form a resist pattern. Further, a ratio of a C1s peak intensity to a W4d peak intensity (C1s/W4d) measured by XPS (X-ray Photoelectron Spectroscopy) at the surface of the tungsten film before coating the chemically amplified resist after the pretreatment step is 0.1 or more.

Further, in a method of manufacturing a semiconductor device according to another typical embodiment, after performing a pretreatment step of coating a substrate having a tungsten film formed on the surface with an organic solvent mixed with a polymeric organic compound, the substrate is coated with a chemically amplified resist to form a resist pattern. Further, an angle of contact with water is 10° or more at the surface of the tungsten film after the pretreatment step and before coating the substrate with the chemically amplified resist.

Further, in a method of manufacturing a semiconductor device according to a further typical embodiment, after performing a pretreatment step of coating a substrate having a tungsten film formed on the surface with a resist for pretreatment and removing the coated resist for pretreatment, the substrate is coated with a chemically amplified resist to form a resist pattern.

Advantageous effects obtained by typical inventions among those disclosed in the present application are to be described simply as below.

According to typical embodiments, the performance of the semiconductor device can be improved.

### BRIEF DESCRIPTION OF THE DRAWINGS

Fig. 1 is a production process flow chart showing a portion of a resist pattern formation step according to a first embodiment;
Fig. 2 is a cross sectional view of a principal portion of a substrate during the resist pattern formation steps of the first embodiment;
Fig. 3 is a front elevational view schematically showing a configuration of a coating apparatus;
Fig. 4 is a front elevational view showing the periphery of a substrate held to a spin chuck provided to the coating apparatus;
Fig. 5 is a cross sectional view of a principal portion of the substrate during a resist pattern formation step of the first embodiment;
Fig. 6 is a front elevational view showing the periphery of the substrate held to the spin chuck provided to the coating apparatus;
Fig. 7 is a cross sectional view of a principal portion of the substrate during the resist pattern formation step of the first embodiment;
Fig. 8 is a front elevational view showing the periphery of the substrate held to the spin chuck provided to the coating apparatus;
Fig. 9 is a cross sectional view of a principal portion of the substrate during the resist pattern formation step of the first embodiment;
Fig. 10 is a cross sectional view of a principal portion of the substrate during the resist pattern formation step of the first embodiment;
Fig. 11 is a cross sectional view of a principal portion of a substrate during the resist pattern formation step of the first embodiment;
Fig. 12 is a cross sectional view of a principal portion of a substrate during the resist pattern formation step of the first embodiment;
Fig. 13 is a cross sectional view of a principal portion of a semiconductor chip configuring a semiconductor device manufactured by a manufacturing step of the semiconductor device of the first embodiment;
Fig. 14 is a cross sectional view of a principal portion during the manufacturing step of the semiconductor device according to the first embodiment;
Fig. 15 is a cross sectional view of a principal portion during the manufacturing step of the semiconductor device according to the first embodiment;
Fig. 16 is a cross sectional view of a principal portion during the manufacturing step of the semiconductor device according to the first embodiment;
Fig. 17 is a cross sectional view of a principal portion during the manufacturing step of the semiconductor device according to the first embodiment;
Fig. 18 is a cross sectional view of a principal portion during the manufacturing step of the semiconductor device according to the first embodiment;
Fig. 19 is a cross sectional view of a principal portion during the manufacturing step of the semiconductor device according to the first embodiment;
Fig. 20 is a cross sectional view of a principal portion during the manufacturing step of the semiconductor device according to the first embodiment;
Fig. 21 is a cross sectional view of a principal portion during the manufacturing step of a semiconductor device according to the first embodiment;
Fig. 22 is a cross sectional view of a principal portion during the manufacturing step of the semiconductor device according to the first embodiment;
Fig. 23 is a cross sectional view of a principal portion during the manufacturing step of the semiconductor device according to the first embodiment;
Fig. 24 is a cross sectional view of a principal portion during the manufacturing step of a semiconductor device according to the first embodiment;
Fig. 25 is a cross sectional view of a principal portion during the manufacturing step of the semiconductor device according to the first embodiment;
Fig. 26 is a graph showing a relation between a line width of a formed resist pattern and a line width of a mask pattern;
Fig. 27 is a cross sectional view of a principal portion of a comparative example 1 in which pattern exfoliation occurs;
Fig. 28 is a graph showing the result of measurement for C1s/W4d;
Fig. 29 is a graph showing the result of measurement for the angle of contact with water;
Fig. 30 is a production process flow chart showing a portion of a resist pattern formation step in a second embodiment;
Fig. 31 is a production process flow chart showing a portion of the resist pattern formation step in a third embodiment;
Fig. 32 is a front elevational view schematically showing the configuration of a coating apparatus;
Fig. 33 is a front elevational view showing the periphery of a substrate held to a spin chuck provided to the coating apparatus;
Fig. 34 is a cross sectional view of a principal portion of a substrate during a resist pattern formation step of a third embodiment;
Fig. 35 is a front elevational view showing the periphery of a substrate held to a spin chuck provided to a coating apparatus;
Fig. 36 is a cross sectional view of a principal portion of a substrate during the resist pattern formation step of a third embodiment;
Fig. 37 is a graph showing a relation between a line width of a formed resist pattern and a line width of a mask pattern; and
Fig. 38 is a production process flow chart showing a portion of a resist pattern formation step of a fourth embodiment.

### DETAILED DESCRIPTION OF THE PREFERRED EMBODIMENTS

In the embodiments described below, the invention will be described in a plurality of sections or embodiments when required for the sake of convenience. However, these sections or embodiments are not irrelevant to each other unless otherwise specified, and the one relates to a part or the entirety of the other as modification examples, details, or supplementary explanation thereof.

Also, in the embodiments described below, when referring to the number of elements, etc. (including number of pieces, values, amount, range, and the like), the number of the elements is not limited to a specific number unless otherwise stated or except the case where the number is apparently limited to the specific number in principle. A number larger or smaller than the specified number is also applicable.

Further, in the embodiments described below, it goes without saying that the constituent elements (including element steps) are not always indispensable unless otherwise specified or except the case where they are apparently indispensable in principle. Similarly, in the embodiments described below, when the shape of constituent elements, positional relationship thereof, and the like are mentioned, substantially approximate and similar shapes or the like are included therein unless specified particularly or except the case where it is conceivable that they are apparently excluded in principle. They are applicable also for the numerical values and the ranges described above.

Preferred embodiments of the invention are to be described in details with reference to the drawings. Throughout the drawings for explaining the embodiments, components having the same function are denoted by the same reference symbols and repetitive description thereof is to be omitted. Further, in the following embodiments, description for identical or similar portions is not repeated in principle unless this is particularly necessary.

Further, in the drawings used for the embodiments, hatching may be sometimes omitted even in a cross sectional view so as to make the drawings easy to see. Further, even in a plan view, hatching may be sometimes used so as to make the drawings to easy to see.

### First Embodiment

### < Resist pattern formation step >

A resist pattern formation step in a first embodiment of the invention is to be described with reference to the drawings. In the resist pattern formation step of this embodiment, a chemically amplified resist applied over the substrate having a tungsten (W) film formed over the surface is patterned (fabricated, removed selectively).

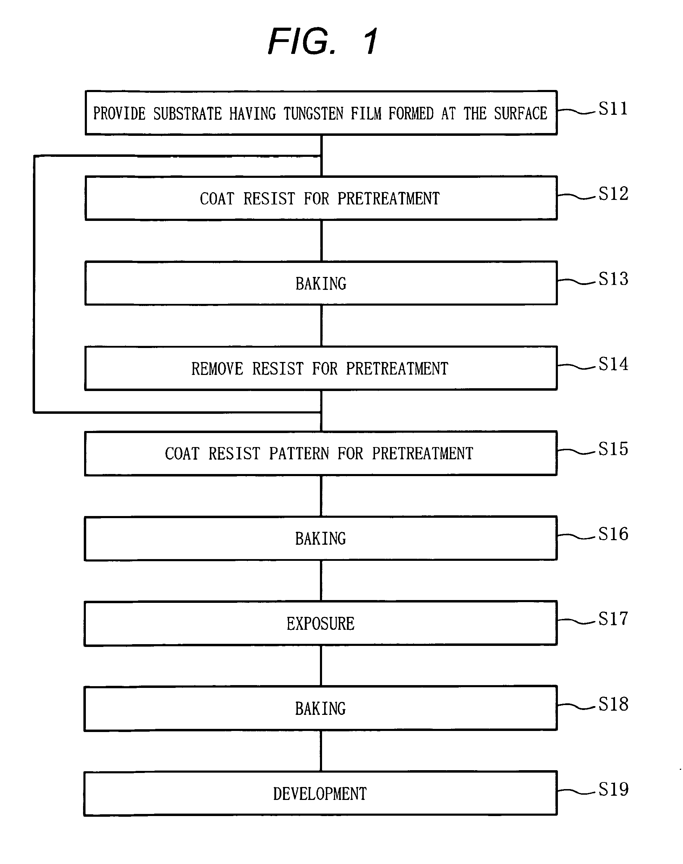

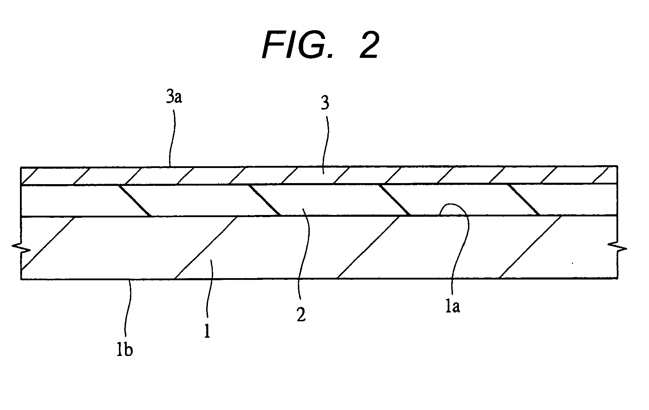

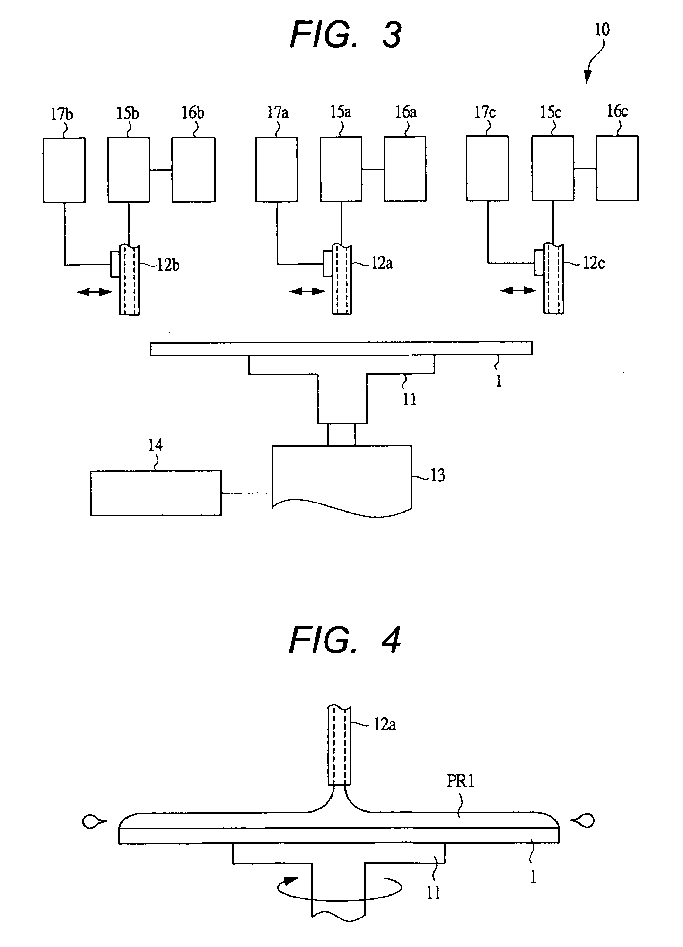

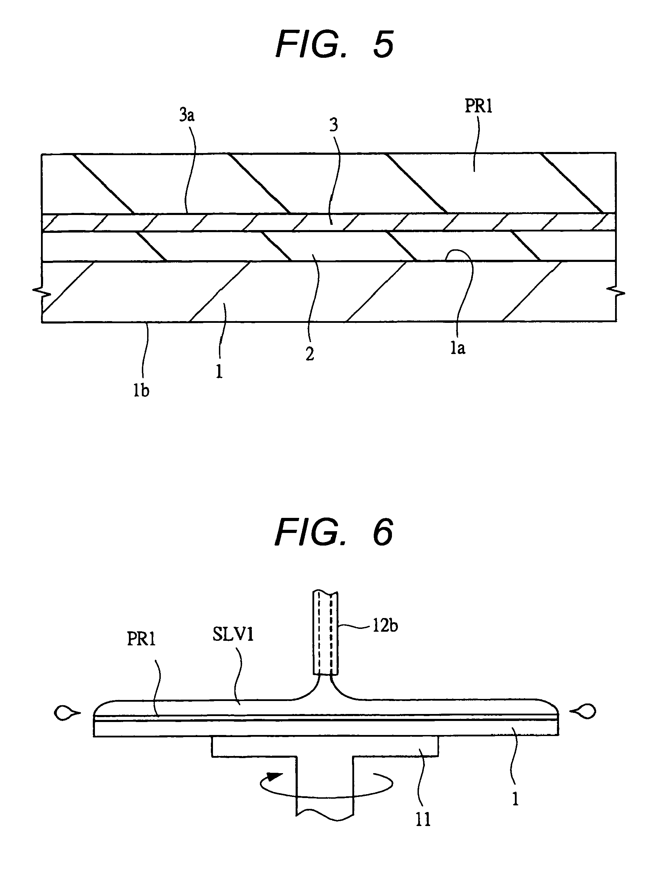

Fig. 1 is a production process flow chart showing a portion of a resist pattern formation step of the first embodiment. Fig. 2, Fig. 5, Fig. 7, and Fig. 9 to Fig. 12 are cross sectional views for principal portions of a substrate 1 during the resist pattern formation step of the first embodiment. Fig. 3 is a front elevational view schematically showing the configuration of a coating apparatus 10. Fig. 4, Fig. 6, and Fig. 8 are front elevational views showing the periphery of the substrate held to a spin chuck 11 provided to the coating apparatus 10. Each of Fig. 5, Fig. 7 and Fig. 9 shows a cross section for a principal portion of the substrate 1 shown in each of Fig. 4, Fig. 6, and Fig. 8 in an enlarged scale.

At first, the substrate 1 having a tungsten (W) film 3 formed on the surface is provided (step S11 in Fig. 1).

As shown in Fig. 2, the substrate 1 comprises, for example, a semiconductor substrate of silicon (Si) single crystals and has a first main surface (upper surface, surface) 1a and a second main surface (lower surface, rearface) 1b situated on the sides opposite to each other along the direction of the thickness. Then, an insulation film 2 comprising, for example, a silicon oxide (SiO₂) film is formed over the entire surface of the first main surface 1a, and a tungsten film 3 is formed on the insulation film 2. That is, the tungsten film 3 is formed as a surface layer to the first main surface (upper surface, surface) 1a of the substrate 1. Further, the surface of the tungsten film 3 is denoted as 3a.

As the substrate 1, various types of substrates, for example, a glass substrate can be used in addition to the semiconductor substrate (also in the subsequent embodiments).

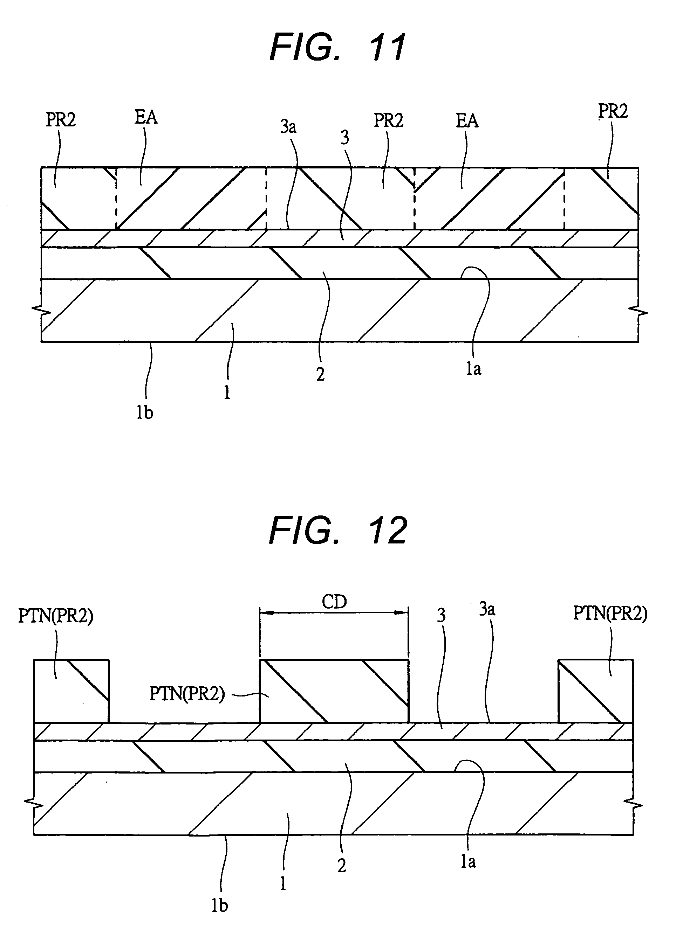

Then, the substrate 1 is coated with the a resist PR1 for pretreatment (step S12 in Fig. 12).

In the step S12, at first, a provided substrate 1 is conveyed by a substrate conveyor device (not illustrated) to the coating apparatus 10, for example, a spin coater (in Fig. 3).

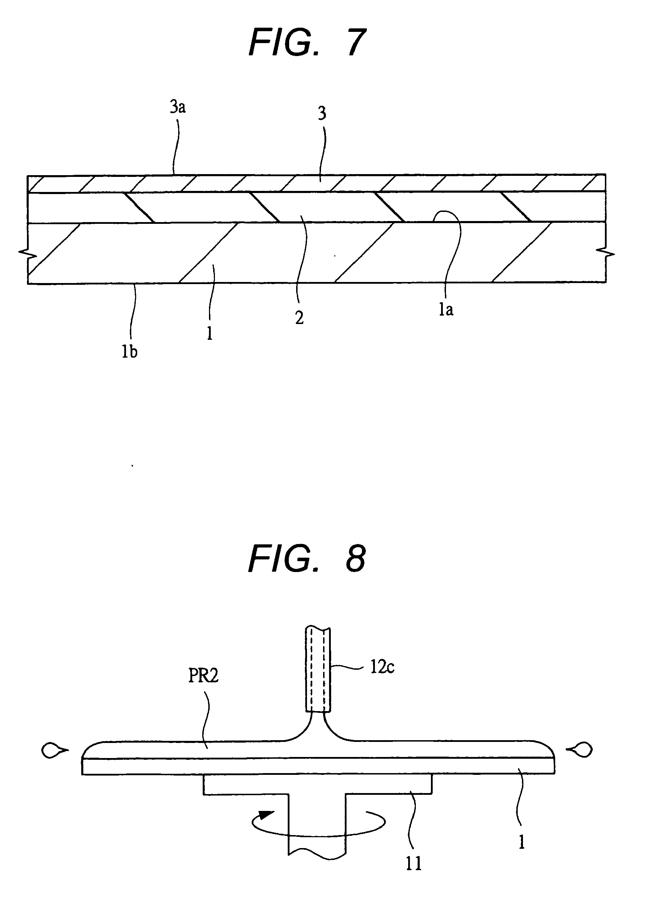

The coating apparatus 10 coats the substrate 1 with the resist PR1 for pretreatment by supplying the resist for treatment (photoresist) PR1 over the substrate 1 in a state of rotating the substrate 1 (refer to Fig. 4 to be described later). Further, the coating apparatus 10 removes the resist (photoresist) PR1 by supplying an organic solvent SLV1 onto the substrate 1 in a state of rotating the substrate 1 coated with the resist PR1 for pretreatment (refer to Fig. 6 to be described later). Further, the coating apparatus 10 coats the substrate 1 with a resist PR2 for resist pattern formation by supplying the resist (photoresist) PR2 for resist pattern formation onto the substrate 1 (refer to Fig. 8 to be described later).

As shown in Fig. 3, the coating apparatus 10 comprises a spin chuck 11 disposed rotatably in a state of holding the substrate 1, for example, by vacuum adsorption, nozzles (12a, 12b and 12c arranged above the substrate 1, etc.

A motor 13 is connected to the spin chuck 11, and the motor 13 is connected to a rotation control section 14. The rotation control section 14 controls the number of rotation of the motor 13 such that the substrate 1 held to the spin chuck 11 connected to the motor 13 is rotated at a predetermined number of rotation.

The nozzle 12a is connected to a supply section 15a for supplying the resist PR1 for pretreatment (refer to Fig. 4 to be described later) and the supply section 15a is connected to a supply control section 16a. The supply control section 16a controls the resist PR1 for pretreatment such that the resist is supplied from the supply section 15a through the nozzle 12a onto the substrate 1 at a predetermined timing.

The nozzle 12b is connected to a supply section 15b for supplying an organic solvent SLV1 (refer to Fig. 6 to be described later) and the supply section 15b is connected to a supply control section 16b. The supply control section 16b controls the organic solvent SLV1 such that the solvent is supplied from the supply section 15b through the nozzle 12b onto the substrate 1 at a predetermined timing corresponding to the number of rotation of the substrate 1.

The nozzle 12c is connected to a supply section 15c for supplying a resist PR2 for forming a resist pattern (refer to Fig. 8 to be described later) and the supply section 15c is connected to a supply control section 16c. The supply control section 16c controls the resist PR2 for resist pattern formation such that the resist is supplied from the supply section 15c through the nozzle 12c onto the substrate 1 at a predetermined timing corresponding to number of rotation of the substrate 1.

Further, the nozzle 12a, 12b, and 12c are arranged moveably by the respective nozzle moving mechanisms 17a, 17b, and 17c and adapted such that when one of the nozzles is situated above the center of the substrate 1, other nozzles can retract, for example, further to the outside of the outer circumference of the substrate 1.

In Fig. 4, Fig. 6, and Fig. 8 to be described later, the motor 13, the rotation control section 14, the supply sections 15a to 15c, the supply control sections 16a to 16c, and the nozzle moving mechanisms 17a to 17c in the coating apparatus 10 are not illustrated.

Further, instead of the coating apparatus 10, a plurality of coating apparatus each comprising, for example, a spin coater or a dip coater may be disposed and each of the resist PR1 for pretreatment, the organic solvent SLV1, and the resist PR2 for resist pattern formation can be supplied by separate coating apparatus, etc. respectively.

The substrate 1 conveyed to the coating apparatus 10 is held to the spin chuck 11, for example, by vacuum adsorption. Then, in a state of rotating the substrate 1 held to the skin chuck 11 together with the spin chuck 11 by the motor 13, the nozzle 12a is moved to a position above the center of the substrate 1 and the resist PR1 for pretreatment is discharged from the moved nozzle 12a onto the substrate 1. Since the discharged resist PR1 for pretreatment flows over the substrate 1 from the center to the outer circumference by a centrifugal force, and the surface 3a of the tungsten film 3 formed on the first main surface (upper surface, surface) 1a of the substrate 1 is coated with the resist PR1 for pretreatment as shown in Fig. 5.

The resist PR1 for pretreatment is not particularly restricted so long as the resist increases a carbon concentration or increases an angle of contact with water on the surface 3a of tungsten film 3 in a state where the resist PR1 for pretreatment is removed, compared with the state before coating of the resist PR1 for pretreatment, and various types of resists (photoresist) can be used. Accordingly, the resist PR1 for pretreatment may not always be a resist identical with PR2 for forming resist pattern to be described later, or it may not be a chemically amplified resist.

The thickness of the coating resist PR1 for pretreatment to be coated is not particularly restricted so long as the thickness is enough to increase the carbon concentration or increase the angle of contact with water at the surface 3a of the tungsten film 3 in a state where the resist PR1 for pretreatment is removed compared with the state before coating of the resist PR1 for pretreatment and it can be set, for example, to about 1 µm.

Before the step S12, that is, before coating the substrate 1 with the resist PR1 for pretreatment, a surface treatment may be applied to the substrate 1 by using, for example, hexamethyldisilazane (HMDS).

Then, the substrate 1 coated with the resist PR1 for pretreatment is baked (heat treated) (step S13 in Fig. 1).

The substrate 1 coated with the resist PR1 for pretreatment in the step S13 is conveyed, for example, to a position above a hot plate provided to a heat treatment device (not illustrated) by a substrate conveyor device (not illustrated) to perform baking (heat treatment) to the substrate 1 by a hot plate. By the baking (heat treatment), the coated resist PR1 for hot treatment can be secured to the substrate 1 and contamination due to adherence of the resist PR1 for pretreatment to each of components of the device conveyor device, etc. in the subsequent steps can be suppressed. The condition for the baking (heat treatment) depends on the material of the resist PR1 for heat treatment, etc. and it can be set, for example, to 90 sec at 90°C.

Then, the coated resist PR1 for pretreatment is removed (step S14 in Fig. 1).

In the step S14, the substrate 1 coated with the resist PR1 for pretreatment and baked (heat treated) is conveyed by the substrate conveyor device (not illustrated) to the coating apparatus 10. The substrate 1 conveyed to the coating apparatus 10 is held to the spin chuck 11. Then, in a state of rotating the substrate 1 held to the held chuck 11 by the motor 13 together with the spin chuck 11, the nozzle 12b is moved to a position above the center of the substrate 1 as shown in Fig. 6 and the organic solvent SLV1, for example, a thinner is discharged from the moved nozzle 12b onto the substrate 1. Since the discharged organic solvent SLV1 flows from the center to the outer circumference over the substrate 1 by a centrifugal force, and the resist PR1 for pretreatment applied over the substrate 1 is dissolved, the coated resist PR1 for pretreatment (refer to Fig. 5) is removed as shown in Fig. 7. That is, the coated resist PR1 for pretreatment is removed by supplying the organic solvent SLV1 onto the substrate 1.

While the method of removing the coated resist PR1 for pretreatment, a method of supplying the organic solvent SLV1 to the substrate 1 is preferred but various other methods, for example, a treatment of ashing the substrate 1 can also be used.

For the substrate 1 from which the resist PR1 for pretreatment has been removed, it is preferred that the ratio of a C1s peak intensity to a W4d peak intensity (C1s/W4d) measured by an X-ray photoelectron spectroscopy (XPS) is 0.1 or more and, more preferably, 0.7 or more. As will be described later, if C1s/W4d is less than 0.1, exfoliation of the formed resist pattern from the tungsten film cannot be suppressed for the line width of a mask pattern (mask size) within the entire range of 200 to 1,000 nm. On the other hand, when C1s/W4d is 0.1 or more, exfoliation of the formed resist pattern from the tungsten film can be suppressed more effectively compared with the case where C1s/W4d is less than 0.1. Particularly, when C1s/W4d is 0.7 or more, exfoliation of the formed resist pattern from the tungsten film can be suppressed in a range of the mask pattern line width (mask size) in a range of 700 nm or more.

The C1s peak intensity measured by XPS means an intensity of a peak observed in a region where the value on the abscissa (energy) corresponds to the energy of photoelectrons excited from the 1s orbital of carbon (C) in the spectrum observed by XPS, which depends on the amount of carbon (C) to be determined by elemental analysis. Further, the W4d peak intensity measured by XPS means an intensity of a peak observed in a region where the value on the abscissa (energy) corresponds to the energy of photoelectrons excited from the 4d orbital of tungsten (W) in the spectrum observed by XPS, which depends on the amount of tungsten (W) to be determined by elemental analysis.

Alternatively, for the substrate 1 from which the resist PR1 for pretreatment has been removed, it is preferred that the angle of contact θ with water at the surface 3a of the tungsten film 3 is from 10 to 90 degree and, more preferably, 50 to 90 degree. As will be described later, if the angle of contact θ is less than 10 degree, exfoliation of the formed mask pattern from the tungsten film cannot be suppressed for the line width of the mask pattern (mask size) within the entire range of 200 to 1,000 nm. On the other hand, when the angle of contact θ is 10 degree or more, exfoliation of the formed resist pattern from the tungsten film can be suppressed more effectively compared with a case where the angle of contact θ is less than 10 degree. Particularly, when the angle of contact θ is 50 degree or more, exfoliation of the formed resist pattern from the tungsten film can be suppressed for the line width of the mask pattern (mask size) within a range of 700 nm or more. If the angle of contact θ exceeds 90 degree, a treating solution, for example, of hydrophilic property is repelled at the surface of the tungsten film.

The steps from step S12 to step S14 may be repeated for several times. That is, the pretreatment step comprising coating of the resist PR1 for pretreatment (step S12), baking (step S13), and removal of the resist PR1 for pretreatment (step S14) may be repeated for several times. As will be described later, by repeating the treating steps, C1s/W4d at the surface of the tungsten film can be increased further.

Then, the substrate 1 is coated with a resist PR2 for resist pattern formation (step S15 in Fig. 1).

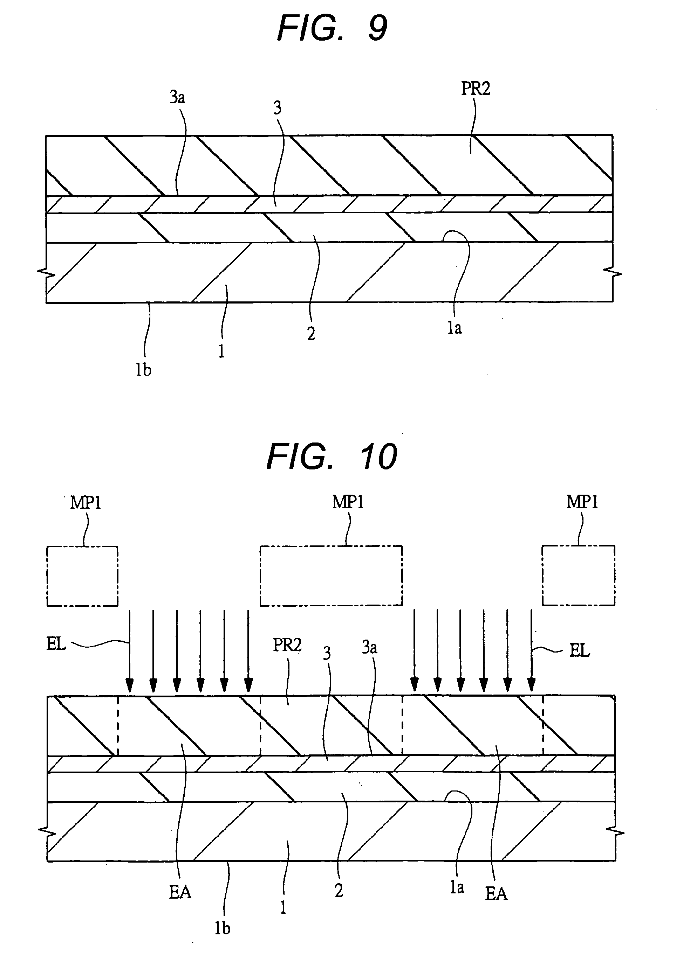

In the step S15, succeeding to the step S14, the nozzle 12c is moved to a position above the center of the substrate 1 as shown in Fig. 8 in a state of rotating the substrate 1 held to the spin chuck 11 by the motor 13 together with the spin chuck 11, and the resist PR2 for resist pattern formation is discharged from the moved nozzle 12c onto the substrate 1. Since the discharged resist pattern PR2 for resist pattern formation flows from the center to the outer circumference over the substrate 1 by a centrifugal force, the surface 3a of the tungsten film 1 formed over the first main surface (upper surface, surface) 1a of the substrate 1 is coated with a resist pattern PR2 for resist pattern formation as shown in Fig. 9.

The coating thickness of the resist PR2 for resist pattern formation depends, for example, on the pattern size of the formed resist pattern (line width) and the thickness of the film (tungsten film 3) to be etched, it can be set, for example, to about 1 µm.

For the resist PR2 for resist pattern formation, a chemically amplified resist is used preferably. While a usual resist is solubilized in a developer by photoreaction upon exposure, the chemically amplified resist generates an acid in the resist by photoreaction upon exposure and is solubilized in the developer upon baking (heat treatment) after exposure by the reaction of the base resin of the resist under the effect of the generated acid as a catalyst. Even when the amount of the acid generated upon exposure is small, since the reaction of solubilizing the resist proceeds in a chained fashion under the effect of the acid as a catalyst upon baking (heat treatment) after exposure, the chemically amplified resist has an extremely higher sensitivity to exposure light than that of usual resist. Accordingly, when KrF excimer laser light having a relatively small intensity as an exposure light is used, the chemically amplified resist is used preferably.

Then, the substrate 1 coated with the resist PR2 for resist pattern formation is baked (heat treated) (step S16 in Fig. 1).

In the step S16, the substrate 1 coated with the resist PR2 for resist pattern formation is conveyed, for example, to a position above a hot plate provided to the heat treatment device (not illustrated) and baking (heat treatment) is applied to the substrate 1 by the hot plate. By the baking (heat treatment), the coating resist PR2 for resist pattern formation can be secured to the substrate 1 and contamination caused by adherence of the resist PR2 for the resist pattern formation, etc. to each of the components of the substrate conveyor device or the exposure device can be suppressed in the subsequent steps. The condition for baking (heat treatment), depending on the material of the resist PR2 for resist pattern formation, can be set to 90°C for 90 seconds, for example.

Then, the baked (heat treated) substrate 1 is exposed (step S17 in Fig. 1).

In the step S17, the substrate 1 coated with the resist PR2 for resist pattern formation and baked (heat treated) is conveyed over a stage provided to an exposure device (not illustrated) by a substrate conveyor device (not illustrated), and exposed by exposure light EL using a mask pattern MP1 as shown in Fig. 10. That is, a mask pattern MP1 is transferred to the resist PR2 by exposure light EL.

The exposure device preferably has, for example, a light source comprising, for example, a KrF excimer laser and a reduction projection optical system, and light from the light source exposes the substrate 1 disposed on the stage by exposure light EL projected under reduction by way of the reduction projection optical system having a photomask. In this step, a light shielding pattern formed to the photomask forms a mask pattern MP1 projected under reduction to the substrate 1 by way of the reduction projection optical system. In the present specification, the line width of the mask pattern MP1 (mask size) is defined not as a line width of the light shielding pattern formed to the photomask but a line width of pattern where the light shielding pattern is projected under reduction to the substrate 1. Further, in the step S17, each of a plurality of regions of the substrate 1 is exposed repeatedly by the exposure light EL by using the mask pattern MP1. In Fig. 10, the mask pattern MP1 is shows by an imaginary line and an exposed area of the coated resist PR2 for resist pattern formation is shown as EA.

Further, in this embodiment, exposure can be performed under previously determined exposure conditions, for example, focus value, exposure amount, numerical aperture of an exposure lens, etc. as exposure conditions in the step S17.
Then, the exposed substrate 1 is baked (heat treated) (step S18 in Fig. 1).
In the step S18, the exposed substrate 1 is conveyed by a conveyor device (not illustrated) to a position, for example, above a hot plate (not illustrated) provided to a heat treatment device to bake (heat treat) the substrate 1 by the hot plate. By the baking (heat treatment), the resist PR2 for resist pattern formation reacts under the effect of an acid generated upon exposure as a catalyst in an exposed region EA of the coated resist PR2 for resist pattern formation, whereby the region is solubilized to an alkaline developer as illustrated in Fig 11. The condition for baking (heat treatment) depends on the material of the resist PR2 for resist pattern formation and it can be set, for example, for 90 seconds at 110°C.

Then, the baked (heat treated) substrate 1 is developed (step S19 in Fig. 1).

In the step S19, the exposed substrate 1 is held to a spin chuck (not illustrated) provided to the developing device by a substrate conveyor device (not illustrated) and, in a state of rotating the substrate 1 held to the spin chuck together with the spin chuck, an alkaline developer is discharged from a nozzle (not illustrated) at a position above the center of the substrate 1. Since the discharged developer flows by a centrifugal force from the center to the outer circumference over the substrate 1, the portion of the coated resist PR2 (for resist pattern formation in the exposed region EA (refer to Fig. 1) is dissolved and a resist pattern PTN having a line width CD is formed over the tungsten film 3 formed at the first main surface (upper surface, surface) 1a of the substrate 1 as shown in Fig. 12. That is, by performing the steps from the step 17 to the step 19, the resist PR2 for resist pattern formation coated on the substrate 1 is patterned (fabricated, removed selectively).

As the alkaline developer, an aqueous solution, for example, of tetramethyl ammonium hydroxide (TMAH) is used.

In the resist pattern formation step of this embodiment, after coating the substrate 1 having the tungsten film 3 formed on the first main surface (upper surface, surface) 1a with the resist PR1 for pretreatment and removing the coated resist PR1 for pretreatment, the substrate 1 is again coated with the resist PR2 for resist pattern formation and exposure and development are performed to form a resist pattern PTN. Thus, exfoliation of the formed resist pattern PTN from the tungsten film 3 can be suppressed as will be described later.

The substrate 1 after the development may also be baked (heat treated). Since the resist pattern PTN can be secured by the heat treatment to the tungsten film 3, exfoliation of the formed resist pattern PTN from the tungsten film 3 can be suppressed more effectively.

### < Manufacturing step of semiconductor device >

Then, an example of a manufacturing step of a semiconductor device according to this embodiment including the resist pattern formation step described above is to be explained with reference to the drawings. In this embodiment, description is to be made to the manufacturing step of a semiconductor device in which an MEMS comprising a supersonic sensor as a semiconductor device is formed to a semiconductor substrate as an example. In the following manufacturing step of the semiconductor device, the tungsten film is formed as a lower electrode, an upper electrode, and a metal film for interconnection connected with the lower electrode or the upper electrode.

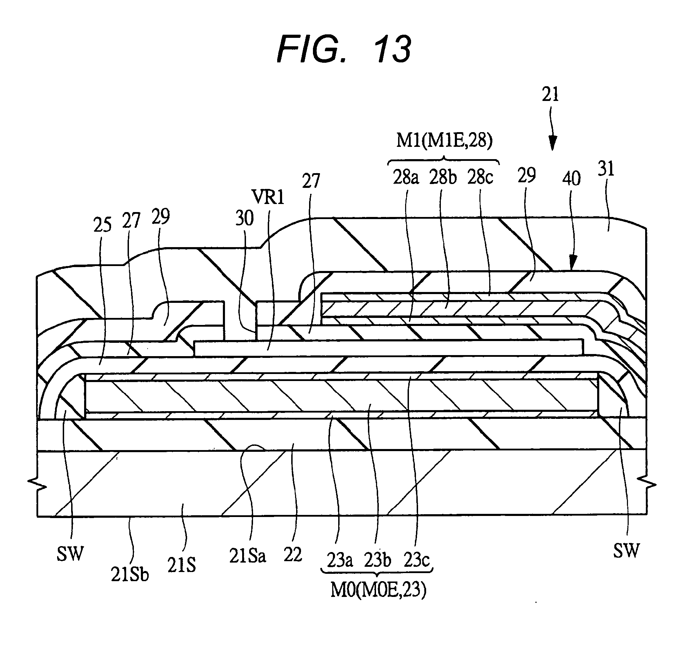

Fig. 13 is a cross sectional view of a principal portion of a semiconductor chip 21 configuring a semiconductor device manufactured by the manufacturing step of the semiconductor device according to the first embodiment.

A semiconductor substrate 21S configuring a semiconductor chip 21 comprises, for example, silicon single crystals and has a first main surface (upper surface, surface) 21Sa and a second main surface (lower surface, rearface) 21Sb situated on the sides opposed to each other along the direction of the thickness. As shown in Fig. 13, an oscillator 40 is disposed (formed) by way of an insulation film 22 comprising, for example, silicon oxide (SiO₂, etc.) film over the main surface 21Sa of the semiconductor substrate 21S.

Further, the oscillator 40 has a lower electrode M0E and an upper electrode M1E opposed to the lower electrode M0E, and a cavity VR1 formed between the electrodes.

In Fig. 13, only one oscillator 40 is shown, but a plurality of oscillators 40 are arranged (formed) in the semiconductor chip 21.

The lower electrode M0E of the oscillator 40 is formed of a portion of a lower electrode interconnect M0. The lower electrode interconnect M0 (lower electrode M0E) comprises a conductor film with a tungsten (W) film being as an uppermost surface layer (stacked film 23) and formed by stacking, for example, a tungsten (W) film 23a, an aluminum (Al) film 23b, and a tungsten (W) film 23c orderly from the lower surface. Alternatively, the lower electrode interconnect M0 (lower electrode M0E) may also be formed only of one tungsten film layer.

On the lateral side of the lower electrode interconnect M0 (lower electrode M0E), a side wall (side wall insulation film) SW comprising an insulator, for example, silicon oxide is formed with a view point of moderating the step caused by the thickness of the lower electrode interconnect M0 (lower electrode M0E). The surfaces of the lower electrode interconnect M0 (lower electrode M0E), the insulation film 22, and the side wall SW are covered by an insulation film 25 comprising, for example, a silicon oxide film.

An insulation film 27 comprising, for example, a silicon oxide film is deposited over the insulation film 25. The upper electrode M1E is disposed over the insulation film 27 so as to oppose the lower electrode M0E.

The upper electrode M1E of the oscillator 40 is formed of a portion of the upper electrode interconnect M1. The upper electrode interconnect M1 (upper electrode M1E) comprises a conductor layer with a tungsten (W) film being as an uppermost surface layer (stacked film 28) and formed by stacking, for example, a tungsten (W) film 28a, an aluminum (Al) film 28b, and a tungsten (W) film 28c orderly from the lower surface. Alternatively, the upper electrode interconnect M1 (upper electrode M1E) may also be formed only of one tungsten film layer.

The cavity VR1 is formed between the lower electrode interconnect M0 (lower electrode M0E) and the upper electrode interconnect M1 (upper electrode M1E) (between the insulation film 25 and the insulation film 27).

An insulation film 29, comprising, for example, a silicon nitride (Si₃N₄, etc.) film is deposited over the insulation film 27 so as to cover the upper electrode interconnect M1 (upper electrode M1E). In the insulation films 27 and 29, a hole (opening) 30 that reaches the cavity VR1 is formed near the cavity VR1. The hole 30 is a hole used for etching a sacrificial pattern between the insulation films 25 and 27 through the hole 30 to form a cavity VR1 (sacrificial pattern 26 is to be described later).

An insulation film 31 comprising, for example, a silicon nitride film is deposited over the insulation film 29. A portion of the insulation film 31 intrudes into the hole 30 thereby closing the hole 30.

Although not illustrated in the drawing, an opening that reaches a portion of the lower electrode interconnect M0 is formed in the insulation films 25, 27, 29, and 31, and a portion of the lower electrode interconnect M0 exposed from the opening may form a pad as an input/output terminal of the semiconductor chip 21. Further, although not illustrated, an opening that reaches a portion of the upper electrode interconnect M1 is formed in the insulation film 29 and 31 and a portion of the upper electrode interconnect M1 exposed through the opening may form a pad as an input/output terminal of the semiconductor chip 21.

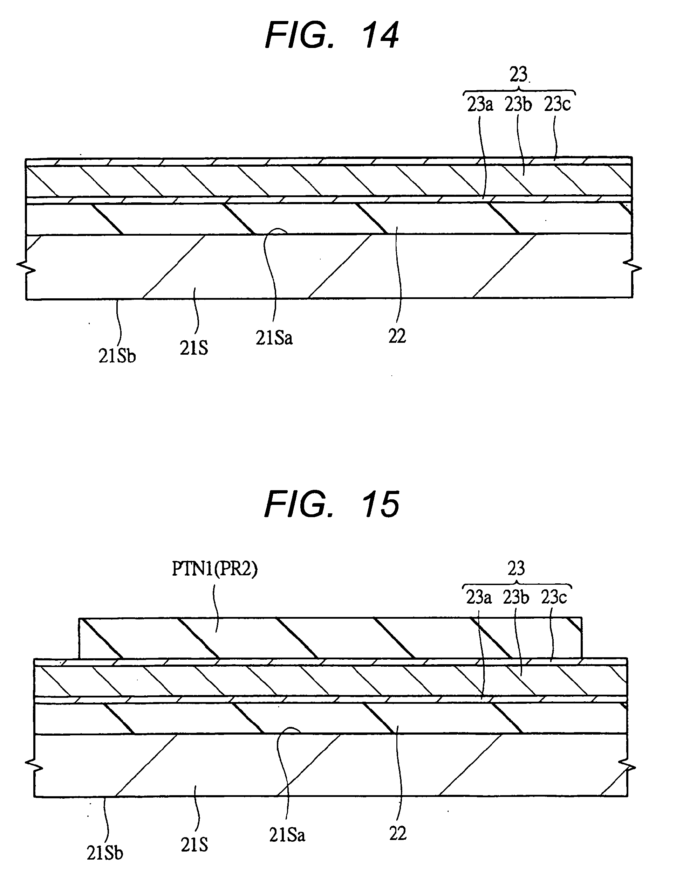

Then, a manufacturing step of a semiconductor device of this embodiment is to be described. Fig. 14 to Fig. 25 are cross sectional views for principal portions during the manufacturing step of the semiconductor device of the first embodiment.

For manufacturing the semiconductor chip 21, a semiconductor substrate (a substantially circular semiconductor thin plate in a plan view which is referred to as a semiconductor wafer in this stage) 21S is at first provided as illustrated in Fig. 14. The semiconductor substrate 21S comprises, for example, silicon single crystals and has a first main surface (upper surface, surface) 21Sa and a second main surface (lower surface, rearface) 21Sb situated on the sides opposed to each other along the direction of the thickness.

Then, an insulation film 22 comprising, for example, a silicon oxide (SiO₂ etc.) film is formed (deposited) over the entire surface of the first main surface 21Sa of the semiconductor substrate 21S. The thickness of the insulation film 22 can be set, for example, to about 40 nm.

Then, a tungsten (W) film 23a is formed on the insulation film 22, an aluminum (Al) film 23b is formed on the tungsten (W) film 23a, and a tungsten (W) film 23c is formed on the aluminum film 23b. As shown in Fig. 14, the stacked film 23 comprising a tungsten film 23a, the aluminum film 23b, and the tungsten film 23c is formed over the insulation film 22. In this state, the tungsten film 23c is formed as a surface layer to the main surface (upper surface, surface) 21Sa of the semiconductor substrate 21S.

The tungsten films 23a and 23c comprise an elemental tungsten film or a conductor film containing tungsten as a main ingredient, for example, a tungsten alloy film. The aluminum film 23b comprises an elemental aluminum film or a conductor film comprising aluminum as a main ingredient, for example, an aluminum alloy film. The tungsten film 23a, the aluminum film 23b, and the tungsten film 23c configuring the staked film 23 can be formed, for example, by using a sputtering method.

Since the aluminum film 23b is a main conductor film of the lower electrode interconnect M0 (lower electrode M0E), the thickness of the aluminum film 23b is larger than the thickness of the tungsten film 23a or 23c and the thickness of the tungsten film 23a can be, for example, about 50 nm, the thickness of the aluminum film 23b can be about 500 nm, and the thickness of the tungsten film 23c can be, for example, about 50 nm.

As described above, the lower electrode interconnect M0 (lower electrode M0E) can also be formed only of the tungsten film.

Then, the stacked film 23 is patterned (fabricated, removed selectively) using, for example, a lithography technique (photolithographic technique) and a dry etching technique.

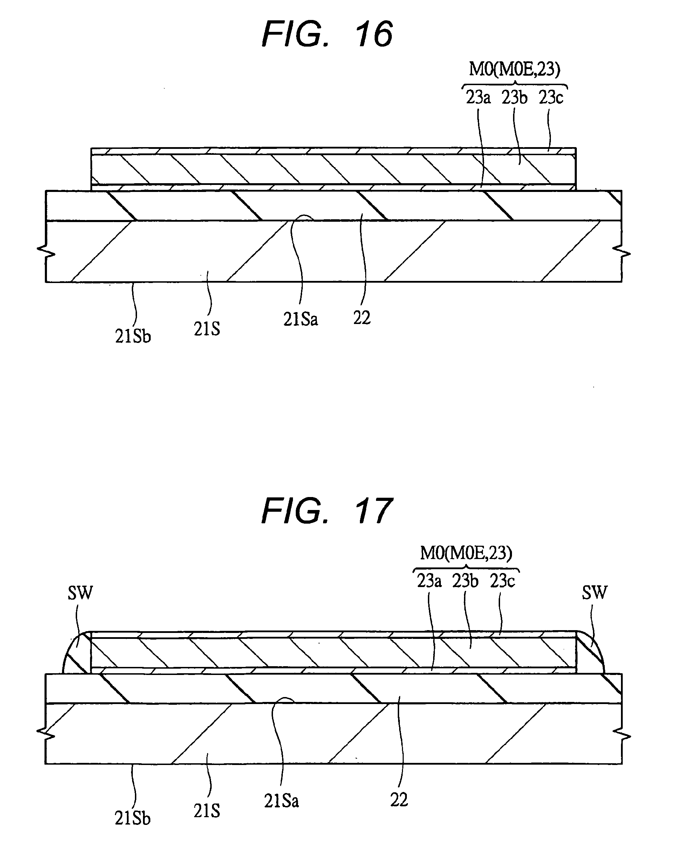

At first, as shown in Fig. 15, a resist pattern PTN1 corresponding to the shape of the lower electrode interconnect M0 (refer to Fig. 16 to be later) is formed over the stacked film 23, that is, over the tungsten film 22c by using a lithographic technique (photolithographic technique). In this embodiment, the resist pattern PTN1 corresponding to the shape of the formed lower electrode interconnect M0 (refer to Fig. 16 to be described later) and comprising a resist PR2 for resist pattern formation is formed by performing the resist pattern formation step (steps S11 to steps S19 in Fig. 1).

In this case, in the resist pattern formation step (step S11 to step S19 in Fig. 1), a semiconductor substrate 21S having a tungsten film 23c formed on the first main surface (upper surface, surface) 21Sa as shown in Fig. 14 is used instead of the substrate 1 having the tungsten film 3 formed on the first main surface (upper surface, surface) 1a as illustrated in Fig. 2. Further, in the step S17 (exposure step) in Fig. 1, a mask pattern corresponding to the shape of the formed lower electrode interconnect M0 (lower electrode M0E) is used. Further, in the step S19 in Fig. 1 (developing step), a resist pattern PTN 1 as illustrated in Fig. 15 is formed instead of the resist pattern PTN as illustrated in Fig. 12.

Then, the stacked film 23 is etched by using a dry etching technique using the formed resist pattern PTN 1 as an etching mask. That is, a portion of the tungsten film 23c, the aluminum film 23b, and the tungsten film 23a not covered by the resist pattern PTN 1 is removed by dry etching. Then, the resist pattern PTN1 is removed, for example, by performing an ashing treatment and a cleaning treatment using a treating solution such as an SPM (Sulfuric acid-Hydrogen Peroxide Mixture) solution. Thus, a lower electrode interconnect M0 fabricated into a desired shape is formed as illustrated in Fig. 16. The lower electrode interconnect M0 is formed on the insulation film 22 and comprises a patterned conductor layer (stacked film 23).

In this embodiment, the resist pattern PTN1 corresponding to the shape of the lower electrode interconnect M0 (lower electrode M0E) is formed. Thus, exfoliation of the formed resist pattern PTN1 from the tungsten film 23c can be suppressed to improve the profiling accuracy of the lower electrode M0E and the lower electrode interconnect M0.

Then, an insulation film such as a silicon oxide film is deposited over the entire surface of the first main surface 21Sa of the semiconductor substrate 21S (that is, on the insulation film 22), so as to cover the surface of the lower electrode interconnect M0 (lower electrode M0E) and the insulation film is etched back by an anisotropic dry etching technology (entire etching). Thus, as illustrated in Fig. 17, the insulation film is left on the lateral side (side wall) of the lower electrode interconnect M0 (lower electrode M0E) to form a side wall (side wall insulation film) SW and expose the upper surface of the lower electrode interconnect M0 (lower electrode M0E).

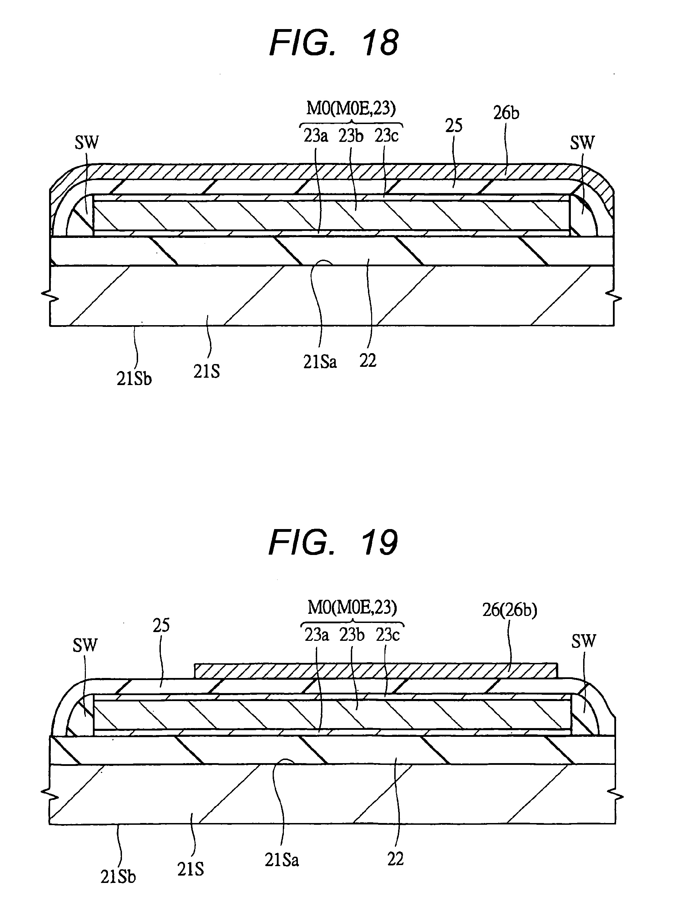

Then, as illustrated in Fig. 18, an insulation film 25 and a sacrificial film 26b are formed (deposited) successively over the entire first main surface 21Sa of the semiconductor substrate 21S (that is, over the insulation film 22) so as to cover the surfaces of the lower electrode interconnect M0 (lowering electrode M0E) and the side wall SW. The insulation film 25 comprises, for example, a silicon oxide film and can be formed by using, for example, a CVD (chemical vapor deposition) method. The thickness of the insulation film 25 is, for example, about 200 nm. The sacrificial film 26b comprises, for example, a polycrystalline silicon film and can be formed, for example, by a CVD method. The thickness of the sacrificial film 26b can be set, for example, to about 100 nm.

Then, as illustrated in Fig. 19, a sacrificial pattern 26 comprising the scarification film 26b is formed by patterning the sacrificial film 26b by a lithographic technique and a dry etching technique. The sacrificial pattern 26 is a pattern for forming the cavity VR1. Accordingly, the planar shape of the scarification pattern 26 is formed into a planar shape identical with that of the cavity VR1.

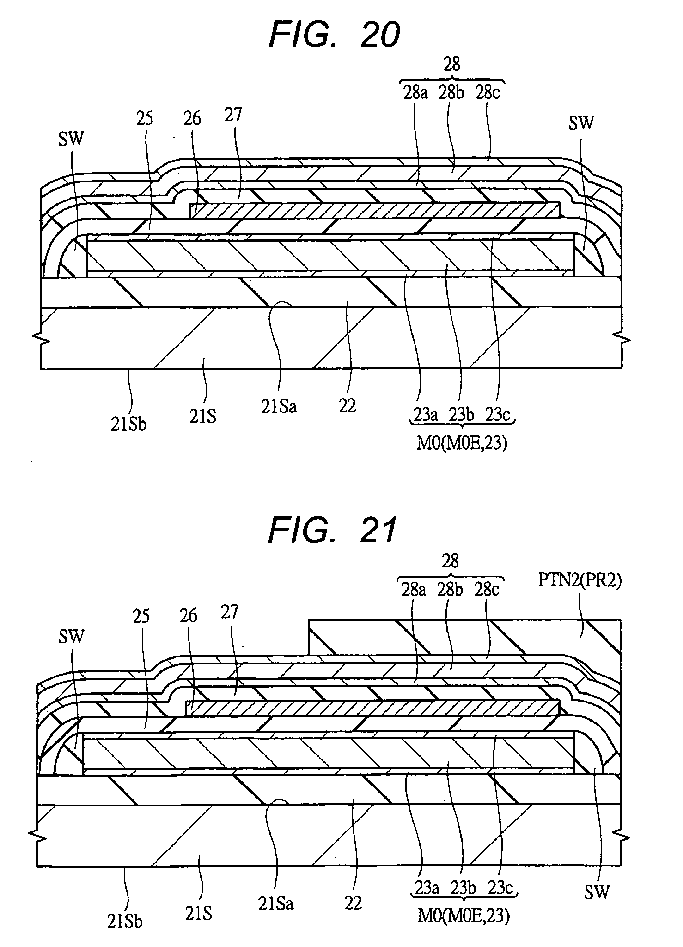

Then, as illustrated in Fig. 20, an insulation film 27 is formed (deposited) over the entire first main surface 21Sa of the semiconductor substrate 21S (that is, over the insulation film 25) so as to cover the surface of the sacrificial pattern 26. The insulation film 27 comprises, for example, a silicon oxide film and can be formed by using, for example, a CVD method. The thickness of the insulation film 27 can be set, for example, to about 200 nm.

Then, a tungsten (W) film 28a is formed on the insulation film 27, an aluminum (Al) film 28b is formed on the tungsten film 28a, and a tungsten (W) film 28c is formed on the aluminum film 28b. Thus, as illustrated in Fig. 20, a stacked film 28 comprising the tungsten film 28a, the aluminum film 28b, and the tungsten film 28c is formed on the insulation film 27. In this state, the tungsten film 28c is formed as a surface layer over the first main surface (upper surface, surface) 21Sa of the semiconductor substrate 21S.

The tungsten films 28a and 28c comprise an elemental tungsten film or a conductor film comprising tungsten as a main ingredient, for example, a tungsten alloy film. The aluminum film 28b comprises an elemental aluminum film or a conductor film comprising aluminum as a main ingredient, for example, an aluminum alloy film. The tungsten film 28a, the aluminum film 28b, and the tungsten film 28c configuring the stacked film 28 can be formed by using, for example, a sputtering method.

Since the aluminum film 28b is a main conductor film of the upper electrode interconnect M1 (upper electrode M1E), the thickness of the aluminum film 28b is larger than the thickness of the tungsten film 28a or 28c. Further, the entire thickness of the stacked film 28 for forming the upper electrode interconnect is smaller than the entire thickness of the stacked film 3 for forming the lower electrode interconnect formation and can be set, for example, to about 400 nm. In this case, each thickness of the tungsten film 28a, the aluminum film 28b, and the tungsten film 28c can be set, for example, to about 50 nm, 300 nm, and 50 nm, respectively.

As has been described above, the upper electrode interconnect M1 (upper electrode M1E) can be formed only of the tungsten film.

Then, the stacked film 28 is patterned (fabricated, removed selectively) by using, for example, a lithographic technique (photolithographic technique) and a dry etching technique.

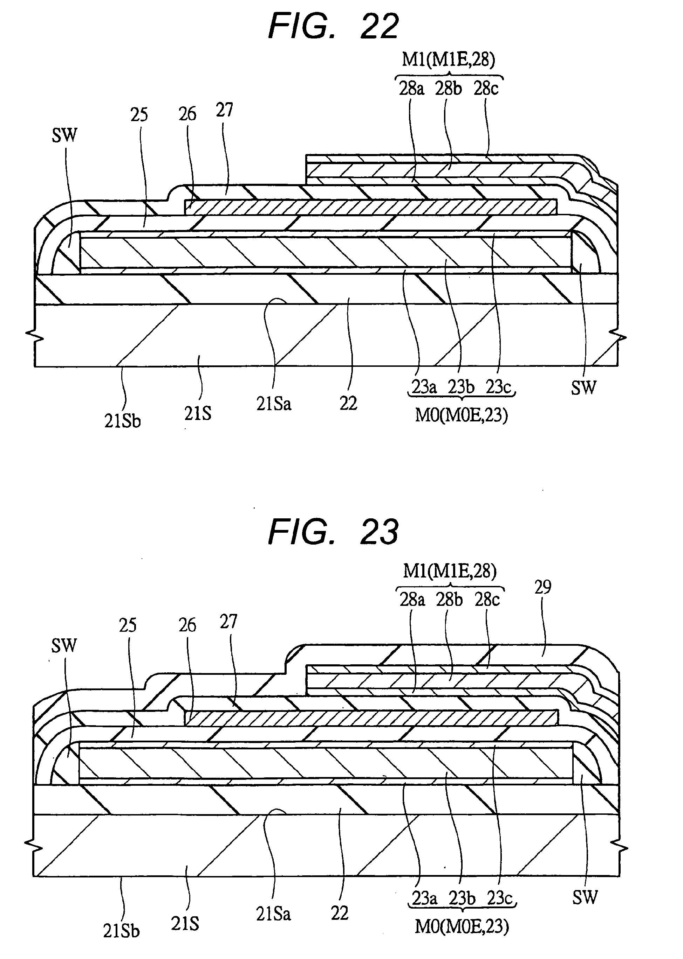

At first, as shown in Fig. 21, a resist pattern PTN2 corresponding to the shape of the upper electrode interconnect M1 (refer to Fig. 22 to be described later) is formed on the stacked film 28, that is, on the tungsten film 28c by using a lithographic technique (photolithographic technique). In this embodiment, a resist pattern PTN2 corresponding to the shape of the formed upper electrode interconnect M1 (refer to Fig. 22 to be described later) and comprising a resist PR2 for resist pattern formation is formed by performing the resist pattern formation step (step S11 to step S19 in Fig. 1).

In this case, a semiconductor substrate 21S having a tungsten film 28c formed on a first main surface (upper surface, surface) 21Sa as illustrated in Fig. 20 is used instead of the substrate 1 having the tungsten film 3 formed on the first main surface (upper surface, surface) 1a as shown in Fig. 2 in the resist pattern formation step (step S11 to step S19 in Fig. 1). Further, a mask pattern corresponding to the shape of the upper electrode interconnect M1 (upper electrode M1E) formed in the step S1 in Fig. 1 (exposure step) is used. Further, in the step S19 in Fig. 1 (developing step), a resist pattern PTN 2 as illustrated in Fig. 21 is used instead of the resist pattern PTN as illustrated in Fig. 12.

Then, the stacked film 28 is etched using the formed resist pattern PTN2 as an etching mask by using a dry etching technique. That is, a portion of the tungsten film 28c, the aluminum film 28b, and the tungsten film 28a not covered with the resist pattern PTN2 is removed by dry etching. Then, the resist pattern PTN2 is removed, for example, by an ashing treatment and a cleaning treatment using a treating solution such as an SPM solution. Thus, an upper electrode interconnect M1 fabricated into a predetermined shape is formed as shown in Fig. 22. The upper electrode interconnect M1 is formed on the insulation film 27 and comprises a patterned conductor film (stacked film 28 in this case).

In this embodiment, the resist pattern PTN2 corresponding to the shape of the upper electrode interconnect M1 (upper electrode M1E) is formed by performing the resist pattern formation step (step S11 to step S19 in Fig. 1). Thus, exfoliation of the formed resist pattern PTN2 from the tungsten film 28c can be suppressed to improve the profiling accuracy of the upper electrode M1E and the upper electrode interconnect M1.

Then, as illustrated in Fig. 23, an insulation film 29 is formed (deposited) over the entire first main surface 21Sa of the semiconductor substrate 21S (that is, on the insulation film 27) so as to cover the upper electrode interconnect M1 (upper electrode M1E). The insulation film 29 comprises, for example, a silicon nitride (Si₃N₄, etc.) film and can be formed by using, for example, a CVD method or the like. The thickness of the insulation film 29 can be set, for example, to about 500 nm.

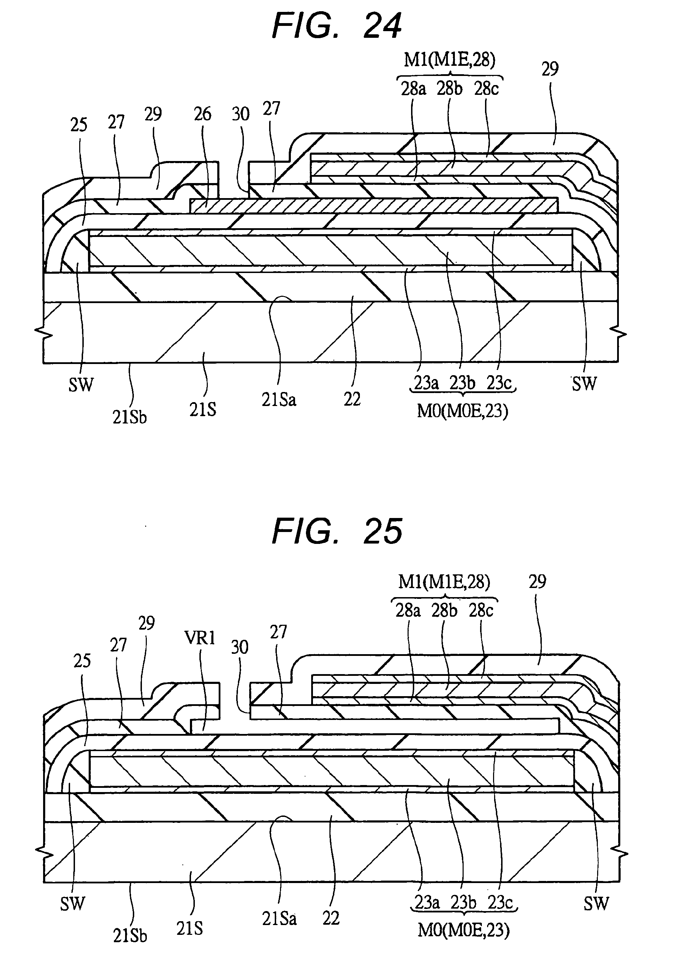

Then, as illustrated in Fig. 24, a hole (opening) 30 is formed in the insulation films 29 and 27 that reaches the sacrificial pattern 26 to expose a portion of the sacrificial pattern 26 by using a lithographic technique and a dry etching technique. The hole 30 is formed at a position overlapping the sacrificial pattern 26 in a plan view and a portion of the sacrificial pattern 26 is exposed at the bottom of the hole 30.

Then, the sacrificial pattern 26 is selectively wet etched by, for example, an aqueous solution of potassium hydroxide through the hole 30. Thus, the sacrificial pattern 26 is removed to form a concave VR1 between the insulation film 25 and the insulation film 27 as illustrated in Fig. 25.

A portion of the lower electrode interconnect M0 that opposes the upper electrode interconnect M1 by way of the concave VR1 is the lower electrode M0E, and a portion of the upper electrode interconnect M1 that opposes the lower electrode interconnect M0 by way of the concave VR1 is the upper electrode M1E.

Then, an insulation film 31 is formed (deposited) over the entire surface of the first main surface 21Sa of the semiconductor substrate 21S (that is, on the insulation film 29). Thus, a portion of the insulation film 31 can be buried in the hole 30 to close the hole 30. The insulation film 31 comprises, for example, a silicon nitride film and can be formed by using, for example, a plasma CVD method. The thickness of the insulation film 31 can be set, for example, to about 800 nm. As shown in Fig. 13, the oscillator 40 is formed as a,capacitance sensor cell.

Then, an opening (not illustrated) a portion of the lower electrode interconnect M0 is formed in the insulation films 31, 29, 27, and 25 and an opening (not illustrated) for exposing a portion of the upper electrode interconnect M1 is formed in the insulation film 31 and 29 by a lithographic technique and a dry etching technique. Successively, the semiconductor chip 21 can be manufactured by cutting out individual chip regions from the semiconductor substrate 21S (semiconductor wafer) by a dicing treatment.

### < Effect of suppressing exfoliation of resist pattern >

Then, the effect of suppressing the exfoliation (pattern exfoliation) of the resist pattern in the resist pattern formation step of this embodiment is to be described. In the followings, a relation between the line width of the resist pattern formed over the tungsten film and the propriety of the patterning is to be evaluated.

At first, a substrate comprising a semiconductor substrate having a tungsten film formed on the surface was provided (step S11 in Fig. 1). Then, the step S12 to step S19 in Fig. 1 were performed to the provided substrate by using a photomask in which a plurality of light shielding patterns each corresponding to the line width (mask size) of the mask pattern different from each other. Further, the line width of the mask pattern (mask size) used herein was 1,000 nm, 700 nm, 500 nm, 450 nm, 400 nm, 360 nm, 320 nm, 280 nm, 240 nm, and 200 nm.

In the following description, the step S12 to the step S14 in the step S11 to the step S19 in Fig. 1 are referred to as the pretreatment step as described previously. Then, Comparative Example 1 shows a case of not performing the pretreatment step, Example 1 shows a case of performing the pretreatment step for once, and Example 2 shows a case of performing the pretreatment step for twice.

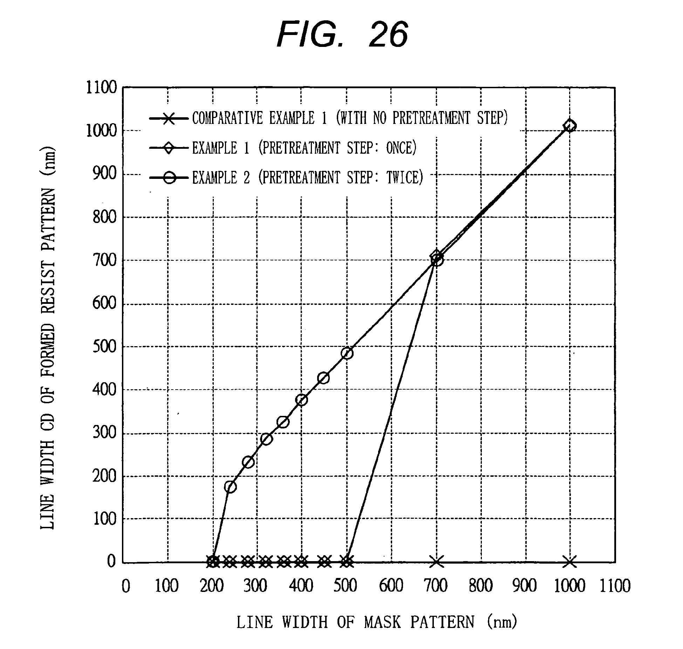

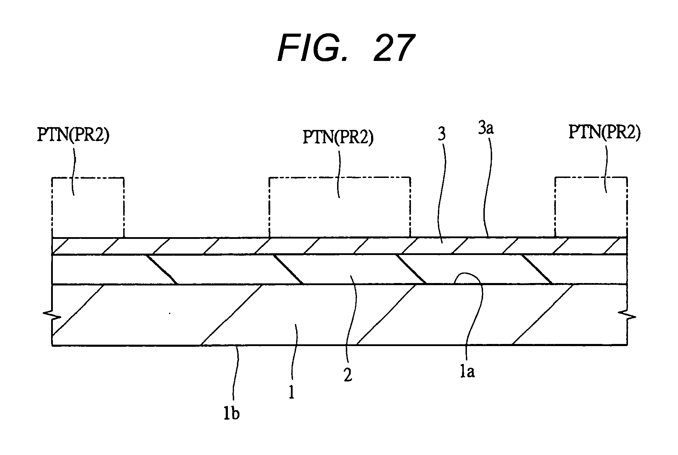

Fig. 26 is a graph illustrating a relation between the line width CD of the formed resist pattern (refer to Fig. 12) and the line width of the mask pattern (mask size) in Comparative Example 1, Example 1, and Example 2. Fig. 27 is a cross sectional view of a principal portion of a substrate 1 in Comparative Example 1 in which the pattern exfoliated. In Fig. 27, the resist pattern PTN comprising the resist PR2 exfoliated, but the resist pattern PTN is shown by a two dot chain line at a position where the pattern should have been formed. The substrate 1 of Example 1 and Example 2 has the cross sectional structure described with reference to Fig. 12, and the substrate 1 of Comparative Example 1 has the same cross sectional structure as the substrate 1 that has been described with reference to Fig. 12 except the resist pattern PTN.

In Fig. 26, when the formed resist pattern did not exfoliate from the tungsten film, the result of measurement is shown with the value of the line width of the mask pattern (mask size) being indicated on the abscissa and the measured value of the line width CD of the formed resist pattern being indicated on the ordinate. On the other hand, when the formed resist pattern exfoliated from the tungsten film, the result of measurement is shown with the value of the line width of the mask pattern (mask size) being indicated on the abscissa, but the line width CD of the resist pattern is shown as 0 on the ordinate since the measured value could not be obtained therefor.

As illustrated in Fig. 26, in Comparative Example 1 (with no pretreatment step), the value on the ordinate is 0 at any value of the line width of the mask pattern (mask size) from 200 to 1,000 nm described above. That is, in Comparative Example 1 (with no pretreatment step), pattern exfoliated (refer to Fig. 27) at any value of the line width of the mask pattern (mask size) from 200 to 1,000 nm.

When the surface treatment was performed by using HMDS before coating the substrate with the resist instead of the pretreatment step described above and then the step S15 to step S19 in Fig. 1 were performed, the pattern exfoliated at any value of the line width of the mask pattern (mask width) from 200 to 1,000 nm like in Comparative Example 1. Accordingly, the surface treatment by HMDS had no effect of suppressing exfoliation of the formed resist pattern from the tungsten film.

Further, when performing a step of coating the substrate with an organic solvent such as a thinner before coating the substrate with the resist and then performing the step S15 to step S19 in Fig. 1 instead of the pretreatment step described above, pattern was exfoliated at any value of the line width of the mask pattern (mask size) from 200 to 1,000 nm like in Comparative Example 1. Accordingly, the surface treatment with the organic solvent had no effect of suppressing exfoliation of the formed resist pattern from the tungsten film.

As shown in Fig. 26, in Example 1 (with pretreatment step for once), the pattern exfoliated at any value of the line width of the mask pattern (mask size) of 500 nm, 450 nm, 400 nm, 360 nm, 320 nm, 280 nm, 240 nm, and 200 nm. However, when the line width (mask size) of the mask pattern is 1,000 nm or 700 nm, the pattern did not exfoliate and a resist pattern having a line width substantially equal with the line width of the mask pattern (mask size) could be formed. Accordingly, it was confirmed that exfoliation of the pattern could be suppressed in Example 1 (pretreatment step for once) compared with Comparative Example 1 (with no pretreatment step).

Further, a pattern exfoliated in Example 2 (pretreatment step for twice) as illustrated in Fig. 26 when the line width of the mask pattern (mask size) was 200 nm. However, the pattern did not exfoliate at any value of the line width of the mask pattern (mask size) of 1,000 nm, 700 nm, 500 nm, 450 nm, 400 nm, 360 nm, 320 nm, 280 nm, and 240 nm as shown in Fig. 26 and a resist pattern having a line width substantially equal with the line width of the mask pattern (mask size) could be formed. Accordingly, it was confirmed that pattern exfoliation could be suppressed further in the second embodiment (pretreatment step for twice) compared with the first embodiment (pretreatment step for once).

Further, a ratio of a C1s peak intensity to a W4d peak intensity (C1s/W4d) was measured by XPS at the surface of the tungsten film before coating the resist for resist pattern formation for Comparative Example 1, and at the surface of the tungsten film after completing the pretreatment step and before coating the resist for resist pattern formation in Example 1 and Example 2. As described above, the C1s peak intensity depends on the amount of carbon (C) determined by elemental analysis and the W4d peak intensity depends on the amount of tungsten (W) determined by elemental analysis. Further, according to XPS, elemental analysis is possible in a range from the surface to a depth of several nm. Accordingly, the ratio of the C1s peak intensity to the W4d peak intensity (C1s/W4d) shows a carbon concentration at the surface of the tungsten film.

The method of calculating each of the peak intensities of the W4d peak or the C1s peak based on the spectrum measured by XPS is not particularly restricted so long as an identical method is used for the W4d peak and the C1s peak. For example, a method of calculating the maximum value for each of the peaks as the peak intensity, or a method of calculating the area for each of the peaks as a peak intensity or like other various methods can be used.

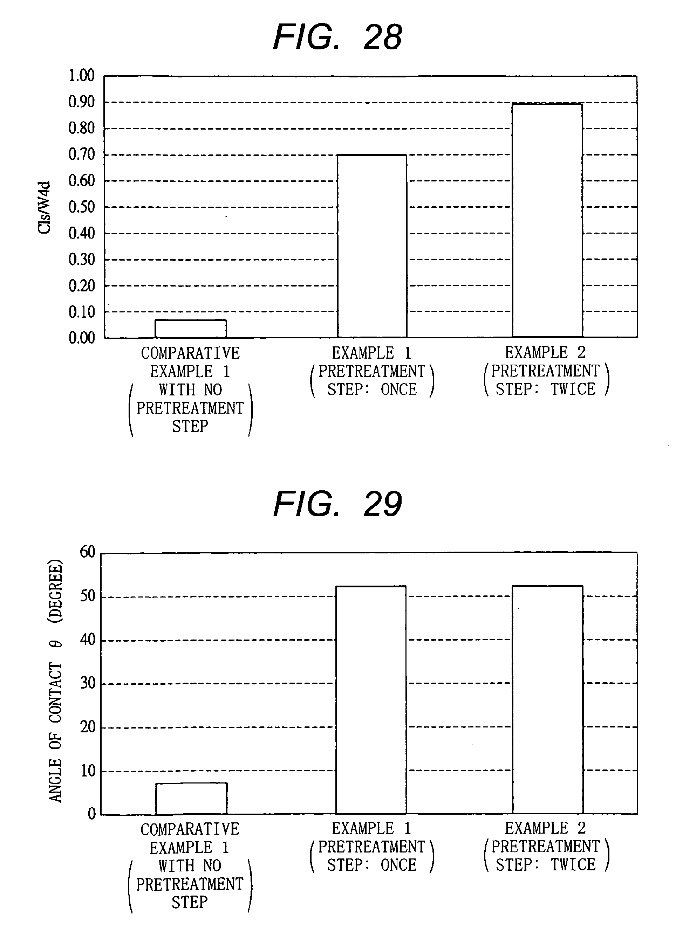

Fig. 28 is a graph illustrating the result of measurement for C1s/W4d in Comparative Example 1, Example 1, and Example 2.

As illustrated in Fig. 28, the value of C1s/W4d is less than 0.1 in Comparative Example 1 (with no pretreatment step) and the value of C1s/W4d is 0.7 or more in Example 1 (pretreatment step for once) and Example 2 (pretreatment step for twice). Accordingly, in view of the result of Fig. 26 and Fig. 28, if C1s/W4d is less than 0.1, pattern exfoliation cannot be suppressed for the line width of the mask pattern (mask size) within the entire range from 200 to 1,000 nm. Further, when C1s/W4d is 0.7 or more, pattern exfoliation can be suppressed for the line width of the mask pattern (mask size) within a range of 700 nm or more.

Although not illustrated in Fig. 28, when the surface treatment was performed by an organic solvent, instead of the pretreatment step, a value of 0.07 was obtained for C1s/W4d and the value of C1s/W4d was less than 0.1 in the same manner as Comparative Example 1 (with no pretreatment step).

Further, an angle of contact θ with water was measured at the surface of the tungsten film before coating of the resist for resist pattern formation in comparative example 1 and after completing all the pretreatment steps and before coating of the resist for resist pattern formation in the first embodiment and the second embodiment. The angle of θ shows a hydrophobicity (water repellency) at the surface of the tungsten film. Further, the angle of contact θ was measured by dropping water to the surface of the tungsten film and observing the shape of dropped water under a microscope.

Fig. 29 is a graph illustrating the result of measurement of the angle of contact θ with water in Comparative Example 1, Example 1, and Example 2.

As illustrated in Fig. 29, the angle of contact θ is less than 10 degree in Comparative Example 1 and the angle of contact θ is 50 degree or more in Example 1 and Example 2. Accordingly, in view of the result of Fig. 26 and Fig. 29, if the angle of contact θ is less than 10 degree, pattern exfoliation cannot be suppressed for the line width of mask pattern (mask size) in an entire range from 200 to 1,000 nm. When the angle of contact θ is 50 degree or more, pattern exfoliation can be suppressed for the line width of the mask pattern (mask size) within a range of 700 nm or more.

Based on the result described above, it can be seen that the carbon concentration increases to improve the hydrophobicity (water repellency) at the surface of the tungsten film before coating of the resist for resist pattern formation in Example 1 and Example 2 compared with the case of not performing the pretreatment step.

Further, as illustrated in Fig. 28, since the value of C1s/W4d in the second embodiment is larger than the value of C1s/W4d in the first embodiment, it can be seen that C1s/W4d further increases by repeating the pretreatment step. That is, it can be seen that the carbon concentration increases more and the hydrophobicity (water repellency) is improved more by repeating the pretreatment steps. Accordingly, it can be seen that the carbon concentration or the hydrophobicity (water repellency) at the surface of the tungsten film can be controlled by controlling the number of repetition of the pretreatment step.

### < Main feature and effect of this embodiment >

As described above, in this embodiment, after performing the pretreatment step of coating the substrate having the tungsten film formed on the surface with a resist for pretreatment and removing the coated resist for pretreatment, a resist for resist pattern formation is coated and the coated resist for resist pattern formation is patterned. Since this increases the carbon concentration and improves the hydrophobicity (water repellency) at the surface of the tungsten film before coating of the resist for resist pattern formation compared with the case of not performing the pretreatment step, adhesion of the resist pattern at the surface of the tungsten film can be improved.

Accordingly, even when the line width of a transferred mask pattern is fine, that is, even when the line width of the formed resist pattern is fine, exfoliation of the formed resist pattern from the tungsten film can be suppressed. As a result, electrodes or interconnects comprising the tungsten film can be fabricated at a good profiling accuracy and the performance of the manufactured semiconductor device such as MEMS can be improved. Second Embodiment

Then, a method of manufacturing a semiconductor device according to a second embodiment of the invention is to be described. In the first embodiment described above, exposure is performed under predetermined exposure conditions. On the contrary, in the second embodiment, after determining the optimal exposure conditions by using a substrate for test exposure, exposure is performed to a substrate for product production under the determined optimal exposure conditions.

### < Resist pattern formation step and manufacturing step of semiconductor device >

In the resist pattern formation step of the second embodiment, a resist pattern is at first formed over a substrate for test exposure in order to determine optimal exposure conditions.

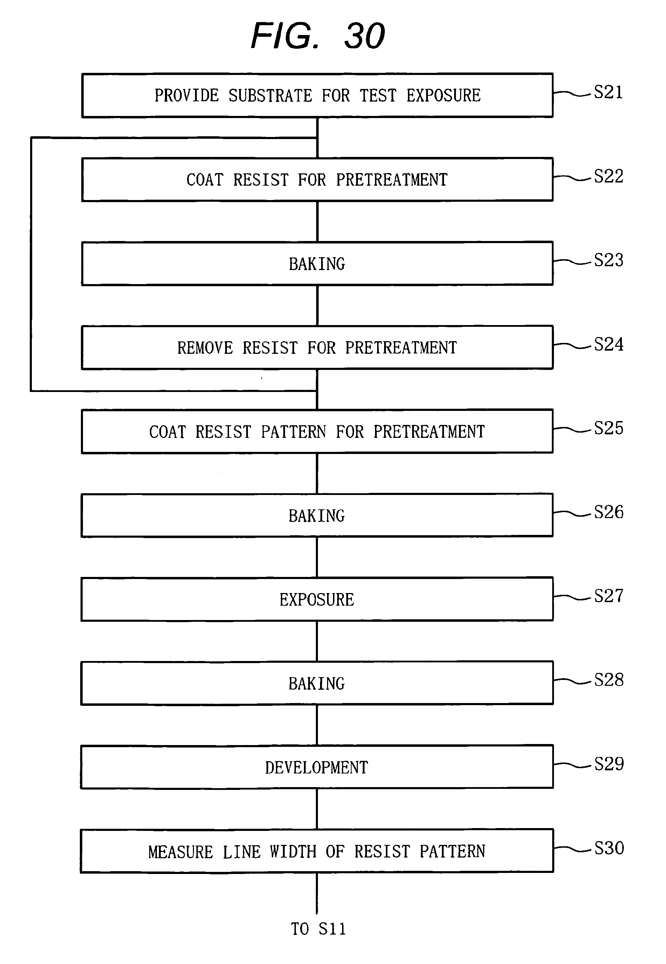

Fig. 30 is a production process flow chart illustrating a portion of resist pattern formation step of the second embodiment. Step S21 to step S30 in Fig. 30 are for forming a resist pattern over the substrate for test exposure and determining the optimal exposure conditions.

At first, a substrate for test exposure having a tungsten film (as a surface layer) formed on the surface is provided (step S21 in Fig. 30). Excepting that the provided substrate is used for test exposure, the step S21 is identical with the step S11 in Fig. 1 in the resist pattern formation step of the first embodiment. Further, the substrate for test exposure provided in the step S21 has a cross sectional structure identical with that of the substrate 1 illustrated in Fig. 2.

Then, after coating the substrate for test exposure with the resist for pretreatment (step S22 in Fig. 30) and baking (heat treating) the substrate for test exposure coated with the resist for pretreatment (step S23 in Fig. 30), the coated resist for pretreatment is removed (step S24 in Fig. 30). Each of the step S22 to the step S24 is identical with each of the steps S12 to step S14 in Fig. 1 in the resist pattern formation step of the first embodiment. Further, the substrate for test exposure to which each of the step S22 and the step S24 has been performed has a cross sectional structure identical with that of the substrate 1 illustrated in each of Fig. 5 and Fig. 7.

For the substrate for test exposure from which the resist for pretreatment has been removed, it is preferred that a ratio of a C1s peak intensity to a W4d peak intensity (C1s/W4d) measured by XPS at the surface of the tungsten film is 0.1 or more and, more preferably, 0.7 or more like in as the first embodiment. Further, it is preferred that the angle of contact θ with water at the surface of the tungsten film is 10 to 90 degree and, more preferably, 50 to 90 degree.

Then, the substrate for test exposure is coated with a resist for resist pattern formation (step S25 in Fig. 30), and the substrate for test exposure,coated with the resist for resist pattern formation is baked (heat treated) (step S26 in Fig. 30). Each of the step S25 and the step S26 is identical with each of the step S15 and the step S16 in Fig. 1 in the resist pattern formation step of the first embodiment. Further, the substrate for test exposure to which the step S25 has been performed has a cross sectional structure identical with that of the substrate 1 illustrated in Fig. 9.

Then, the baked (heat treated) substrate for test exposure is exposed (step S27 in Fig. 30). The step S27 is different from the step S17 in Fig. 1 in the resist pattern formation step of the first embodiment in that a plurality of regions of the substrate for test exposure are exposed under exposure conditions different from each other. Exposure is performed while changing the exposure conditions, for example, a focus value, an exposure amount, the numerical aperture of an exposure lens. Further, the step S27 is identical with the step S17 in Fig. 1 in the resist pattern formation step of the first embodiment except that a plurality of regions are exposed under exposure conditions different from each other. Further, the substrate for test exposure in the step S27 has a cross sectional structure identical with that of the substrate 1 illustrated in Fig. 10.

Then, the exposed substrate for test exposure is baked (heat treated) (step S32 in Fig. 30) and the baked (heat treated) substrate for test exposure is developed (step S29 in Fig. 30). Each of the step S28 and the step S29 is identical with each of the step S18 and the step S19 in Fig. 1 in the resist pattern formation step of the first embodiment. Further, the substrate for test exposure to which each of the step S28 and the step S29 has been performed has a cross sectional structure identical with that of the substrate 1 illustrated in each of Fig. 11 and Fig. 12. That is, a resist pattern is formed over the tungsten film in the substrate for test exposure by performing steps up to the step S29.

Then, the line width of a resist pattern (photoresist pattern) (pattern size) formed over the substrate for test exposure is measured (step S30 in Fig. 30). In the step S30, the line width of the resist pattern (pattern size) CD formed over the tungsten film is measured in each of the plurality of regions exposed under exposure conditions different from each other by a line width measuring device, for example, a scanning electron microscope (SEM), etc. Then, the exposure conditions corresponding to a region where the difference between the measured line width (pattern size) CD and the line width of the mask pattern (mask size) is reduced to the minimum are determined as the optimal exposure conditions. That is, the optimal exposure conditions are determined based on the line width of the resist pattern (pattern size) CD formed in each of the plurality of regions of the substrate for test exposure. The optimal exposure conditions comprise each of the optimal conditions, for example, the focus value, the exposure amount, and the numerical aperture (NA) of the exposure lens as described above.

If the difference between the measured line width (pattern size) CD and the line width of the mask pattern (mask size) is not decreased to less than a predetermined value in each of the plurality of regions, the step S24 in Fig. 30 is performed again and the formed resist pattern can be removed. Subsequently, the optimal exposure conditions can be determined by changing the condition of the light source, for example, an energy of a KrF excimer laser or the resist condition for resist pattern formation, for example, the kind and viscosity of a chemical solution and, by performing the step S25 to the step S30 in Fig. 30 further.

Alternatively, the optimal exposure conditions can be determined by measuring various shape parameters such as the tilting angle of the side wall of the resist pattern instead of the line width of the rest pattern (pattern size) CD and based on the measured shape parameters.

After determining the optimal exposure conditions as described above, a resist pattern is formed over the substrate for product production used for actually manufacturing the semiconductor device. After performing the step S11 in Fig. 1 in the resist pattern formation step of the first embodiment and providing the substrate having the tungsten film formed on the surface as a substrate for product production, the step S12 to step S19 in Fig. 1 are performed in the resist pattern formation step of the first embodiment, thereby forming a resist pattern on the tungsten film in the substrate for product production.

However, in the second embodiment, the substrate for product production is exposed in the step of the step S17 in Fig. 1 under the optimal exposure conditions determined in the step S30 in Fig. 30. That is, each of the plurality of regions in the substrate for product production is exposed under the optimal exposure conditions comprising each of optimal conditions, for example, the focus value, the exposure amount, and the numerical aperture of the exposure lens as described above.

The step S21 and the step S30 in Fig. 30 for the substrate for test exposure may be performed before the step S17 in Fig. 1 to the substrate for product production and, for example, the steps may be performed in parallel with the step S11 to the step S16 in Fig. 1 to the substrate for product production.

Since the manufacturing step for the semiconductor device of the second embodiment including the resist pattern formation step described above can be performed in the same manner as the example for the manufacturing step of the semiconductor device explained for the first embodiment, description therefor is to be omitted.

### < Main feature and effect of this embodiment >

In the second embodiment, since the carbon concentration is increased and the hydrophobicity (water repellency) is improved at the surface of the tungsten film before coating of the resist for resist pattern formation in each of the substrate for test exposure and the substrate for product production in the same manner as in the first embodiment, adhesion of the resist pattern on the surface of the tungsten film can be improved. Accordingly, exfoliation of the formed resist pattern from the tungsten film can be suppressed in each of the substrate for test exposure and the substrate for product production.

Further, in the second embodiment, after determining the optimal exposure conditions by using the substrate for test exposure, the substrate for product production is exposed under the determined optimal exposure conditions. Accordingly, the electrodes or interconnects comprising the tungsten film can be fabricated at a higher profiling accuracy and the performance of the manufactured semiconductor device such as the MEMS can be improved further compared with the first embodiment.

Further, it is preferred that identical substrate and identical resist for pretreatment, identical organic solvent, and identical resist for resist pattern formation are used and other conditions excepting the exposure conditions (for example, number of rotation of substrate, condition for heat treatment, etc.) are made identical between the step S21 to step S29 in Fig. 30 and the step S11 to the step S19 in Fig. 1. Thus, the optimal exposure conditions can be obtained more easily.

### Third Embodiment

Then, a method of manufacturing a semiconductor device according to a third embodiment of the invention is to be described. In the first embodiment described above, the step of coating of the resist for pretreatment and removing the coated resist for pretreatment is performed as the pretreatment step before coating of the resist for resist pattern formation. On the contrary, in the third embodiment, a step of coating of an organic solvent mixed with a high molecular organic compound is performed as a pretreatment before coating of the resist for resist pattern formation.

### < Resist pattern formation step and manufacturing step of semiconductor device >

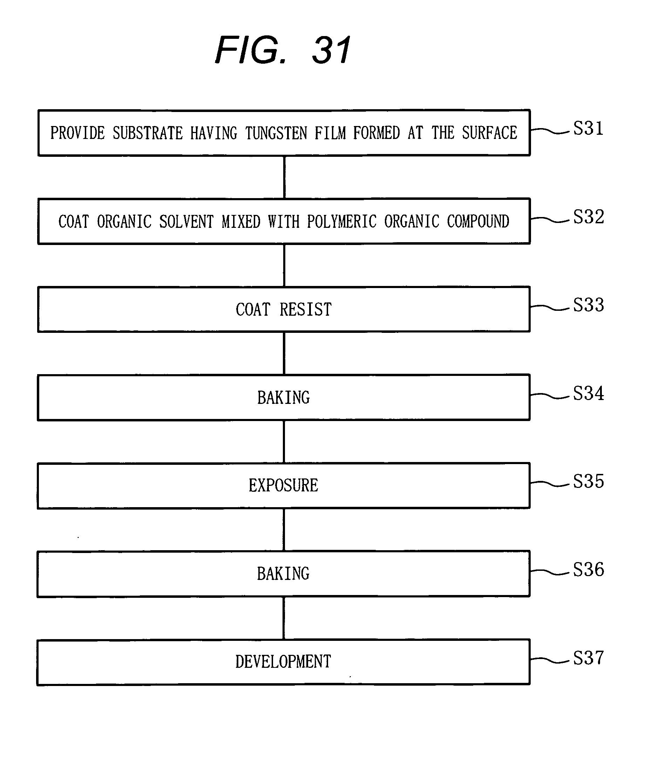

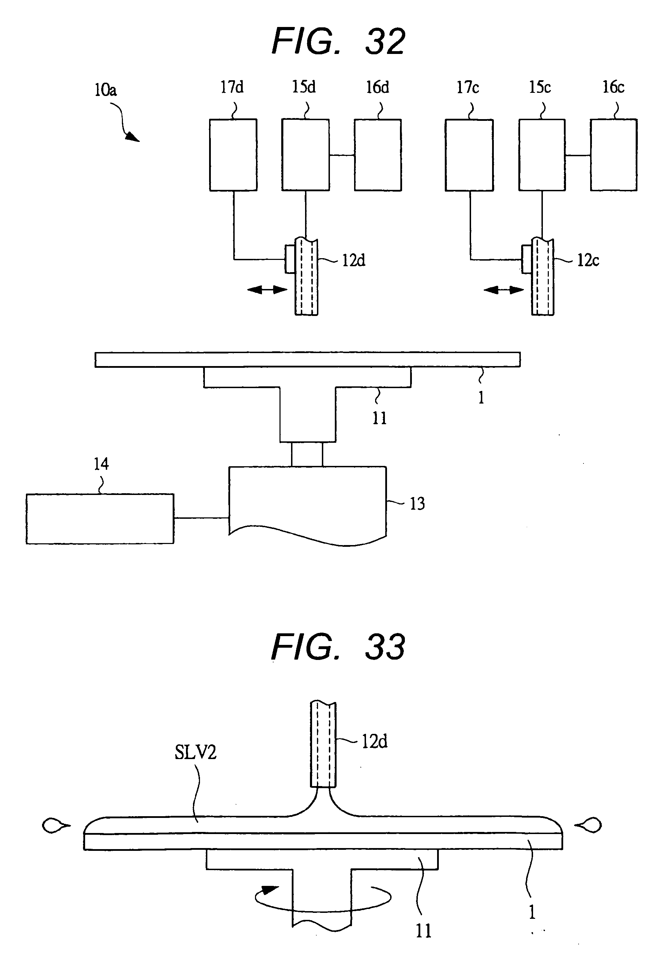

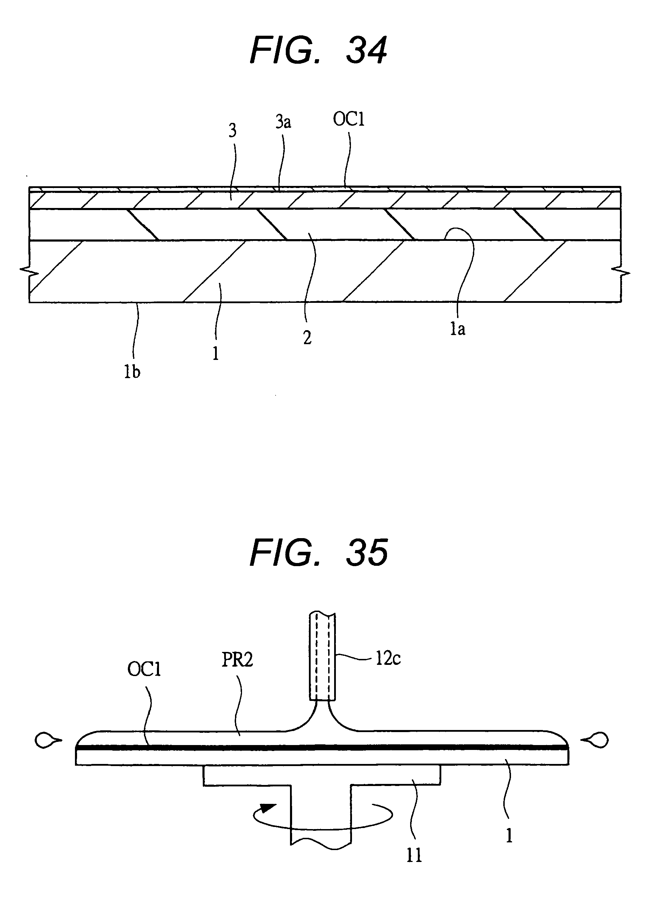

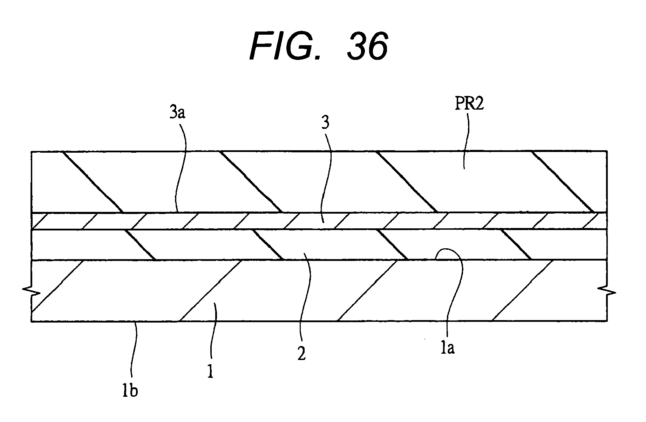

Fig. 31 is a production process flow chart illustrating a portion of a resist pattern formation step of the third embodiment. Fig. 32 is a front elevational view schematically illustrating the configuration of a coating apparatus 10a. Fig. 33 and Fig. 35 are front elevational views illustrating the periphery of a substrate held to a spin chuck 11 provided to the coating apparatus 10a. Fig. 34 and Fig. 36 are cross sectional views for main portions of a substrate 1 during a resist pattern formation step of the third embodiment. Each of Fig. 34 and Fig. 36 illustrates a cross section for the main portion of the substrate 1 illustrated in each of Fig. 33 and Fig. 35 in an enlarged scale.

At first, a substrate 1 having a tungsten (W) film 3 formed over the surface is provided (step S31 in Fig. 31).

The step S31 is identical with the step S11 in Fig. 1 in the resist pattern formation step of the first embodiment. Further, in the step S31, a substrate 1 having a cross sectional structure identical with that of the substrate 1 shown in Fig. 2 can be provided. That is, the substrate 1 comprises, for example, a semiconductor substrate formed such as of silicon single crystals and has a first main surface (upper surface, surface) 1a and a second main surface (lower surface, rearface) 1b situated on the sides opposed to each other along the direction of the thickness. Then, an insulation film 2 comprising, for example, a silicon oxide (SiO₂, etc.) film is formed over the entire first main surface 1a and a tungsten film 3 is formed on the insulation film 2. That is, the tungsten film 3 is formed as a surface layer over the first main surface (upper surface, surface) 1a of the substrate 1. Further, the surface of the tungsten film is shown as 3a.

Then, an organic solvent SLV2 mixed with a polymeric organic compound is coated (step S32 in Fig. 31). In this embodiment, the step S32 corresponds to a pretreatment before coating of the resist for resist pattern formation.

In the step S32, the provided substrate 1 is at first conveyed by a substrate conveyor device (not illustrated) to a coating apparatus 10a, for example, a spin coater (refer to Fig. 32).

The coating apparatus 10a supplies an organic solvent SLV2 mixed with a polymeric organic compound onto the substrate 1 in a state of rotating the substrate 1 (refer to Fig. 33 to be described later), thereby coating the substrate 1 with the organic solvent SLV2 mixed with the polymeric organic compound. Further, the coating apparatus 10a supplies a resist (photoresist) PR2 for resist pattern formation onto the substrate 1 in a state of rotating the substrate 1 (refer to Fig. 35 to be described later), thereby coating the substrate 1 with the resist PR2 for resist pattern formation.

As illustrated in Fig. 32, the coating apparatus 10a includes a spin chuck 11, and nozzles 12c and 12b disposed above the substrate 1, etc.

Since each of a spin chuck 11, a nozzle 12c, a motor 13, a rotation control section 14, a supply section 15c, a supply control section 16c, and a nozzle moving mechanism 17c provided to the coating apparatus 10a is identical with each of the spin chuck 11, the nozzle 12c, the motor 13, the rotation control section 14, the supply section 15c, the supply control section 16, and the nozzle moving mechanism 17c provided to the coating apparatus 10 already described with reference to Fig. 3 of the first embodiment, explanation thereof is to be omitted.

On the other hand, the coating apparatus 10a has no nozzles 12a and 12b, supply sections 15a and 15b, supply control sections 16a and 16b, and nozzle moving mechanisms 17a and 17b provided to the coating apparatus 10.

Further, the nozzle 12d is connected to the supply section 15d for supplying the organic solvent SLV2 mixed with the polymeric organic compound (refer to Fig. 33 to be described later), and the supply section 15d is connected to the supply control section 16d. The supply control section 16d performs control such that the organic solvent SLV2 mixed with the polymeric organic compound is supplied at a predetermined timing from the supply section 15d through the nozzle 12d onto the substrate 1 corresponding to the number of rotation of the substrate 1.

Further, the nozzle 12d is disposed so as to be moveable by the nozzle moving mechanism 17d and arranged such that when one of the nozzles 12c and 12d is situated above the center of the substrate 1, the other of the nozzles can be retracted, for example, further to the outside from the outer circumference of the substrate 1.

In Fig. 33 and Fig. 35 to be described later, the motor 13, the rotation control section 14, the supply sections 15c and 15d, the supply control sections 16c and 16d, and the nozzle moving mechanisms 17c and 17d of the coating apparatus 10a are not illustrated.
Further, instead of the coating apparatus 10a, a plurality of coating apparatus each comprising, for example, a spin coater or a dip coater may be provided and each of the organic solvent SLV2 mixed with the polymeric organic compound and the resist PR2 for resist pattern formation can be supplied by separate coating apparatus respectively.
The substrate 1 conveyed to the coating apparatus 10a is held to the spin chuck 11, for example, by vacuum adsorption. Then, in a state of rotating the substrate 1 held to the skin chuck 11 by the motor 13 together with the spin chuck 11, the nozzle 12d is moved to a position above the center of the substrate 1, and the organic solvent SLV2 mixed with the polymeric organic compound is discharged from the moved nozzle 12d onto the substrate 1, as illustrated in Fig. 33. Since the discharged organic solvent SLV2 mixed with the polymeric organic compound flows over the substrate 1 from the center to the outer circumference by a centrifugal force, the organic solvent SLV2 mixed with the polymeric organic compound is coated onto the substrate 1.
The organic solvent SLV2 mixed with the polymeric organic compound is not particularly restricted so long as the carbon concentration is increased or the angle of contact with water is increased at the surface 3a of the tungsten film 3 after coating of the organic solvent SLV2 compared with the case before coating the organic solvent SLV2. As the organic solvent SLV2 mixed with the polymeric organic compound, those, for example, comprising an organic solvent such as a thinner mixed with a polymeric organic compound comprising phenolic resins such as a novolac resin, polyhydroxystyrene (PHS) resins, and like other various resins can be used. Among them, the novolac resins are suitable in that the effect of increasing the carbon concentration or the effect of increasing the angle of contact with water at the surface of the tungsten film are particularly high.

Depending on the mixing ratio of mixing the polymeric organic compound to the organic solvent or the condition of the number of rotation of the substrate 1, for example, the solvent is evaporated and the polymeric organic compound mixed to the organic solvent is formed remains on the substrate 1, by which a film OC1 containing the polymeric organic compound mixed in the organic solvent on the surface 3a of the tungsten film 3 as illustrated in Fig. 34. In this case, the thickness of the formed film OC1 is not particularly restricted so long as the thickness is sufficient to increase the carbon concentration or increase the angle of contact with water at the surface 3a of the tungsten film 3 compared with the case before coating of the polymeric organic compound mixed to the organic solvent and it can be set, for example, to about 5 nm.

Depending on the mixing ratio of mixing the polymeric organic compound to the organic solvent or the condition for the number of rotation of the substrate 1, the film OC1 is not sometimes formed on the surface 3a of the tungsten film 3 and the substrate 1 of the third embodiment may sometimes has a cross sectional structure identical with that of the substrate 1 illustrated in Fig. 7 of the first embodiment.

Further, the surface treatment for the substrate 1 may also be performed by using, for example, HMDS before the step S32, that is, before coating the substrate 1 with the organic solvent SLV2 mixed with the polymeric organic compound. Further, the substrate 1 may be baked (heat treatment) after the step S32 and before the step S33 to be described later.

As will be described later, it is preferred that the ratio of a C1s peak intensity to a W4d peak intensity (C1s/W4d) measured by XPS is 0.1 or more and, more preferably, 0.7 or more at the surface 3a of the tungsten film 3 coated with the organic solvent SLV2 mixed with the polymeric organic compound. Further, it is preferred that the angle of contact θ with water is from 10 to 90 degree and, more preferably, from 50 to 90 degree at the surface 3a of the tungsten film 3 coated with the organic solvent SLV2 mixed with the polymeric organic compound.

Then, the substrate 1 is coated with the resist PR2 for resist pattern formation (step S33 in Fig. 31).

In the step S33, subsequent to the step S32, the nozzle 12c is moved to a position above the center of the substrate 1 as shown in Fig. 35 in a state of rotating the substrate 1 held to the spin chuck 11 together with the spin chuck 11 by the motor 13, and the resist PR2 for resist pattern formation is discharged onto the substrate 1. Since the discharged resist PR2 for resist pattern formation flows from the center to the outer circumference over the substrate 1, as illustrated in Fig. 36, a resist PR2 for resist pattern formation is coated over the surface 3a of the tungsten film 3 formed on the first main surface (upper surface, surface) 1a of the substrate 1. In Fig. 36, reference 32 denotes an insulation film.

The thickness of the coated resist PR2 for resist pattern formation depends on the pattern size (line width) of the formed resist pattern and the thickness of the film to be etched (tungsten film 3), and it can be set, for example, to about 1 µm.

As the resist PR2 for resist pattern formation, a chemically amplified resist is used preferably in the same manner as the resist PR2 for resist pattern formation of the first embodiment.

When the resist PR2 for resist pattern formation is coated, the film OC1 containing a polymeric organic compound formed on the surface 3a of the tungsten film 3 is integrated with the coated resist PR2 for resist pattern formation. Accordingly, the film OC1 is not illustrated in Fig. 36.

Further, Fig. 35 illustrates a case where the film OC1 is formed in the step S32 in which the formed film OC1 is shown by a fat solid line. On the other hand, when the film OC1 is not formed in the step S32, the state at the periphery of the substrate in the step S33 is identical with the state illustrated in Fig. 8 for the first embodiment.

In the third embodiment, since it is not necessary to distinguish the resist for pretreatment and the resist for resist pattern formation as in the first embodiment, the resist PR2 for resist pattern formation is sometimes referred to simply as a resist PR2.

Then, the substrate 1 coated with the resist PR2 is baked (heat treated) (step S34 in Fig. 31) and the baked (heat treated) substrate 1 is exposed (step S35 in Fig. 31).
Each of the step S34 and the step S35 is identical with each of the step S16 and the step S17 of Fig. 1 in the resist pattern formation step of the first embodiment. Further, the substrate 1 in the step S35 has a cross sectional structure identical with that of the substrate 1 illustrated in Fig. 10.

In this embodiment, exposure can be performed in the step S35 under predetermined exposure conditions, for example, a focus value, an exposure amount, and a numerical aperture of an exposure lens as exposure conditions.

Then, the exposed substrate 1 is baked (heat treated) (step S36 in Fig. 31) and the baked (heated treated) substrate is developed (step S37 in Fig. 31). Each of the step S36 and the step S37 is identical with each of the step S18 and step S19 in Fig. 1 in the resist pattern formation step of the first embodiment. Further, the substrate 1 to which each of the step S36 and the step S37 has been performed has a cross sectional structure identical with that of the substrate shown in each of Fig. 11 and Fig. 12. That is, the resist PR2 coated on the substrate 1 is patterned (fabricated, selectively removed), by performing the step S35 to step S37 and a resist pattern PTN is formed on the tungsten film 3 in the substrate 1.

Since the manufacturing step of the semiconductor device of the third embodiment including the resist pattern formation step described above can be performed in the same manner as the example of the manufacturing step of the semiconductor device that has been described for the first embodiment, description thereof is to be omitted.

### < Effect of suppressing exfoliation of resist pattern >

Then, the effect of suppressing the exfoliation (pattern exfoliation) of the resist pattern in the resist pattern formation step of the third embodiment is to be described. In the followings, a relation between the line width of the resist pattern formed on the tungsten film and the propriety of the patterning is to be evaluated.

At first, a substrate comprising a semiconductor substrate having a tungsten film formed on the surface was provided (step S31 in Fig. 31). Then, the step S32 to step S37 in Fig. 31 were performed to the provided substrate by using a photomask in which a plurality of light shielding patterns corresponding to the line widths (mask size) of the mask pattern different from each other were formed. Further, the line width of the mask pattern used (mask size) were 1,000 nm, 700 nm, 500 nm, 450 nm, 400 nm, 360 nm, 320 nm, 280 nm, 240 nm, and 200 nm.

In the following description, the step S32 in the step S31 to the step S37 in Fig. 31 is referred to as the pretreatment step as described previously. Then, Comparative Example 2 shows a case of not performing the pretreatment step and Example 1 shows a case of performing the pretreatment step. Comparative Example 2 is identical with comparative Example 1 in the first embodiment.

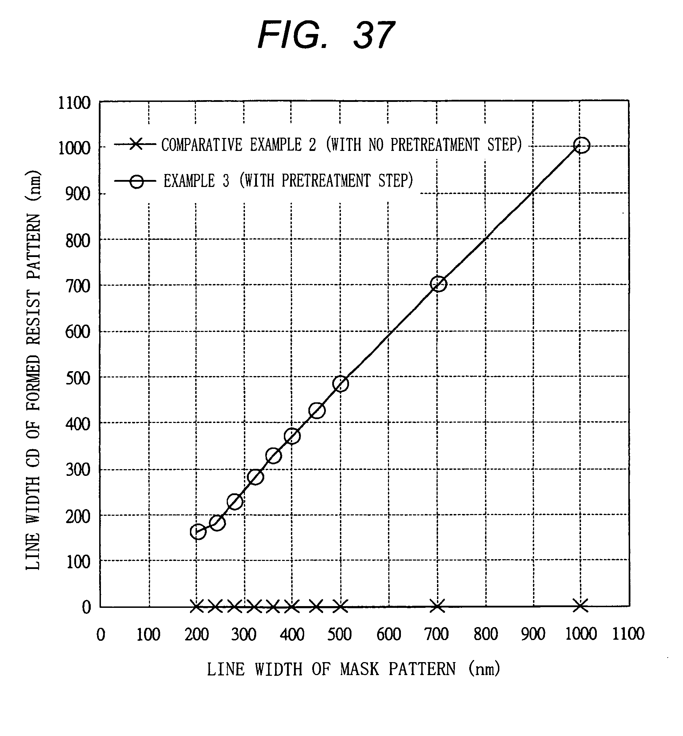

Fig. 37 is a graph illustrating a relation between the line width CD of the formed resist pattern (refer to Fig. 12 described above) and the line width of the mask pattern (mask size) in Comparative Example 2 and the Example 3.

In Fig. 37, when the formed resist pattern did not exfoliate from the tungsten film, the result of measurement is shown with the value on the abscissa as the line width of the mask pattern (mask size) and the value on the ordinate as the measured value of the line width CD of the formed resist pattern. On the other hand, when the formed resist pattern exfoliated from the tungsten film in Fig. 37, the value on the abscissa indicates the line width of the mask pattern (mask size) but since the measured value for the line width CD of the resist pattern was not obtained, the result of measurement is indicated as 0 for the value on the ordinate.

As illustrated in Fig. 37, in Comparative Example 2 (with no pretreatment step), the value on the ordinate is 0 at any value of the line width of the mask pattern (mask size) from 200 to 1,000 nm described above. That is, in Comparative Example 2 (with no pretreatment step), pattern exfoliated (refer to Fig. 27) at any value of the line width of the mask pattern (mask size) from 200 to 1,000 nm.

As described above in the first embodiment, the surface treatment by HMDS and a surface treatment using only the organic solvent have no effect of suppressing exfoliation of the formed resist pattern from the tungsten film.

On the other hand, as shown in Fig. 37, in Example 3 (with pretreatment step), pattern did not exfoliate at any value for the line width of the mask pattern (mask size) of 1,000 nm, 700 nm, 500 nm, 450 nm, 400 nm, 360 nm, 320 nm, 280 nm, 240 nm, and 200 nm, and a resist pattern having substantially the same line width as the line width of the mask pattern (mask size) could be formed. Accordingly, it was confirmed that exfoliation of the pattern can be suppressed in Example 3 (with pretreatment step) compared with Comparative Example 2 (with no pretreatment step).

Further, for Example 3, a ratio of a Cls peak intensity to a W4d peak intensity (C1s/W4d) was measured by XPS at the surface of a tungsten film coated with the organic solvent mixed with the polymeric organic compound after completing the pretreatment step and before coating of the resist. As a result, although measured values could not be obtained since the value of the Cls peak intensity exceeded the measuring limit, it was suggested that the ratio was apparently greater than the value of the Cls/W4d in Example 1 and Example 2 described in the first embodiment.

When the result of Example 3 and Comparative Example 2 described above is considered together with the result of Example 1 and Example 2 described in the first embodiment, it can be seen that the carbon concentration is increased and the hydrophobicity (water repellency) is improved at the surface of the tungsten film before coating of the resist for resist pattern formation also in Example 3 when compared with a case of not performing the pretreatment step. Further, by controlling the mixing ratio of mixing the polymeric organic compound to the organic solvent, it can be controlled such that the carbon concentration or the hydrophobicity (water repellency) at the surface of the tungsten film after the pretreatment step is equal, for example, with the carbon concentration or the hydrophobicity (water repellency) at the surface of the tungsten film after the pretreatment step of the first embodiment.

Accordingly, also in the third embodiment, it is preferred like in the first embodiment that C1s/W4d is 0.1 or more and, more preferably, 0.7 or more at the surface of the tungsten film after the pretreatment step and before coating the resist for resist pattern formation. Further, also in the third embodiment, it is preferred like the first embodiment that the angle of contact θ with water at the surface of the tungsten film after the treatment step and before coating of the resist for resist pattern formation is from 10 to 90 degree and, more preferably, 50 to 90 degree.

### < Principal feature and effect of this embodiment >

Also in the third embodiment, like in the first embodiment, since the carbon concentration is increased and the hydrophobicity (water repellency) is improved at the surface of the tungsten film before coating of the resist for resist pattern formation, adhesion of the resist pattern at the surface of the tungsten film can be improved. Accordingly, exfoliation of the formed resist pattern from the tungsten film can be suppressed, the electrodes and the interconnects comprising the tungsten film can be fabricated at a good profiling accuracy and the performance of the manufactured semiconductor device such as MEMS can be improved.

In the third embodiment, the substrate is not coated with the resist for pretreatment as the pretreatment step. Further, since the resist for pretreatment, it is not necessary to perform the step of removing the coated resist for the pretreatment. Therefore, the number of steps can be saved and the amount of use of the chemical solution can be decreased more compared with the first embodiment. Further, the organic solvent mixed with the polymeric organic compound at an optimal mixing ratio in accordance with the line width of the mask pattern (mask size) can be adjusted easily by controlling the mixing ratio of mixing the polymeric organic compound to the organic solvent and the amount of use of the polymeric organic compound can be decreased.

### Fourth Embodiment

Then, a manufacturing method of the semiconductor device of the fourth embodiment according to the invention is to be described. In the third embodiment described above, exposure is performed under predetermined exposure conditions. On the contrary, in the fourth embodiment, after determining the optimal exposure conditions by using a substrate for test exposure, exposure is performed to the substrate for product production under predetermined optimal exposure conditions.

### < Resist pattern formation step and manufacturing step of semiconductor device >

In the resist pattern formation step of the fourth embodiment, a resist pattern is formed at first to a substrate for test exposure for determining optimal exposure conditions.

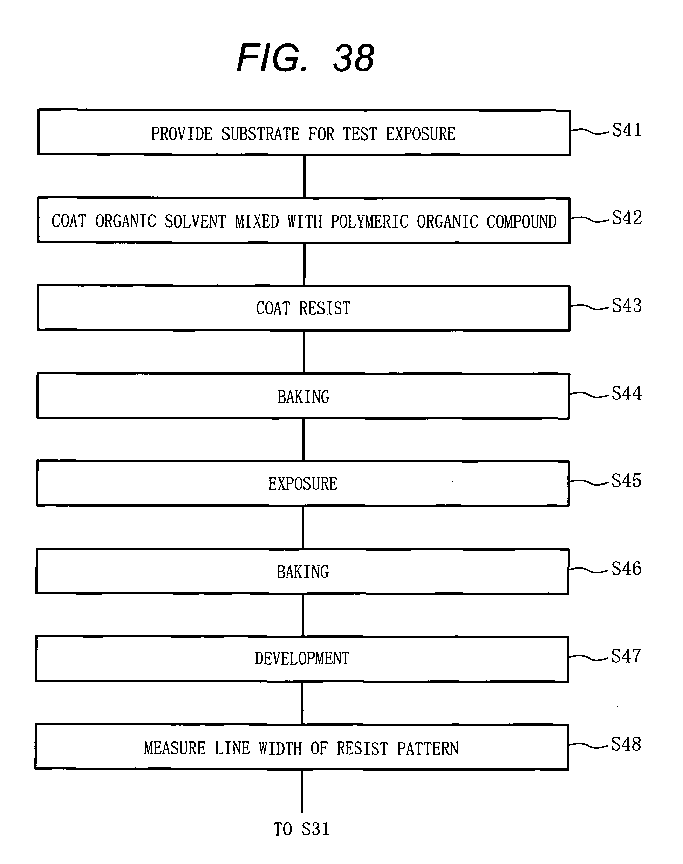

Fig. 38 is a production process flow chart showing a portion of a resist pattern formation step of the fourth embodiment. The step 41 to step 48 in Fig. 38 are performed for forming a resist pattern to a substrate for test exposure and determining optimal exposure conditions.

At first, a substrate for test exposure having a tungsten film (as a surface layer) formed over the surface is provided (step S41 in Fig. 38). The step S41 is identical with the step S31 in Fig. 31 in the resist pattern formation step of the third embodiment except that the provided substrate is used for test exposure. Further, the substrate for test exposure provided in the step S41 has a cross sectional structure identical with that of the substrate 1 illustrated in Fig. 2.

Then, an organic solvent mixed with a polymeric organic compound is coated over the substrate for test exposure (step S42 in Fig. 38). The step S42 is identical with the step S32 in Fig. 31 in the resist pattern formation step of the third embodiment. Further, the substrate for test exposure to which the step S42 has been performed has a cross sectional structure identical, for example, with that of the substrate 1 illustrated in,Fig. 34.

For the substrate for test exposure, it is preferred, like in the third embodiment, that the ratio of a C1s peak intensity to a W4d peak intensity (C1s/W4d) measured by XPS is 0.1 or more and, more preferably, 0.7 or more at the surface of the tungsten film coated with the organic solvent mixed with the polymeric organic compound. Further, it is preferred, like in the third embodiment, that the angle of contact θ with water is 10 to 90 degree and, more preferably, 50 to 90 degree at the surface of the tungsten film coated with the organic solvent mixed with the polymeric organic compound.

Then, the substrate for text exposure is coated with a resist (step S43 in Fig. 38). The step S43 is identical with the step S33 in Fig. 31 in the resist pattern formation step of the third embodiment. Further, the substrate for test exposure to which the step S43 has been performed has a cross sectional structure identical with that of the substrate 1 shown in Fig. 36.

Then, the substrate for test exposure coated with the resist is baked (heat treated) (step S44 in Fig. 38), and the baked (heat treated) substrate for test exposure is exposed (step S45 in Fig. 38). Each of the step S44 and the step S45 is identical with each of the step S34 and the step S35 in Fig. 31 in the resist pattern formation step of the third embodiment. Further, the substrate for test exposure in the step S45 has a cross sectional structure identical with that of the substrate 1 illustrated in Fig. 10.

However, the step S45 is different from the step S35 in Fig. 31 in the resist pattern formation step of the third embodiment in that each of a plurality of regions of the substrate for test exposure is exposed under exposure conditions different from each other. Exposure is performed while changing exposure conditions, for example, a focus value, an exposure amount, or numerical aperture of an exposure lens.

Then, the exposed substrate for test exposure is baked (heat treated) (step S46 in Fig. 38) and the baked (heat treated) substrate for test exposure is developed (step S47 in Fig. 38). Each of the step S46 and the step S47 is identical with each of the step S36 and the step S37 in Fig. 31 in the resist pattern formation step of the third embodiment. Further, the substrate for test exposure to which each of the step S46 and the step S47 has been performed has a cross sectional structure identical with that of the substrate 1 illustrated in each of Fig. 11 and Fig. 12. That is, a resist pattern is formed over the tungsten film in the substrate for test exposure by performing the steps up to the step S47.

The line width (pattern size) of the resist pattern (photoresist pattern) formed over the substrate for test exposure is measured (step S48 in Fig. 38). The step S48 is identical with the step S30 in Fig. 30 in the resist pattern formation step of the second embodiment. Then, optimal exposure conditions comprising each of optimal conditions, for example, a focus value, an exposure amount, and a numerical aperture of an exposure lens are determined based on the line width of the resist pattern (pattern size) CD formed in each of the plurality of regions of the substrate for test exposure.

For example, when the difference between the measured line width (pattern size) CD and the line width of the mask pattern (mask size) is not reduced to less than a predetermined value in each of the plurality of regions, the condition for the light source or the condition for the resist for resist pattern formation described above in the second embodiment is changed. The optimal exposure conditions can be determined by performing the step S41 to step S48 in Fig. 38 again.

Alternatively, the optimal exposure conditions can also be determined based on various shape parameters instead of the line width of the resist pattern (pattern size) CD in the same manner as in the second embodiment.

After determining the optimal exposure conditions as described above, a resist pattern is formed over a substrate for product production for actually manufacturing a semiconductor device. After performing the step S31 in Fig. 31 in the resist pattern formation step of the third embodiment to provide a substrate having a tungsten film formed over the surface as a substrate for product production, the step S32 to step S37 in Fig. 31 in the resist pattern formation step of the third embodiment are performed, to form a resist pattern on the tungsten film in the substrate for product production.

However, in the fourth embodiment, the substrate for product production is exposed in the step S35 in Fig. 31 under the optimal exposure conditions determined in the step S48 in Fig. 38. That is, each of the plurality of regions of the substrate for product production is exposed under the optimal exposure conditions including each of the optimal conditions, for example, the focus value, the exposure amount, and the numerical aperture of an exposure lens as described above.

The step S41 to the step S48 in Fig. 38 for the substrate for test exposure may be performed before the step S35 in Fig. 31 for the substrate for product production, and they may be performed in parallel with the step S31 to step S34 in Fig. 31 for the substrate for product production.

Since the manufacturing step of the semiconductor device of the fourth embodiment including the resist pattern formation step described above can be performed in the same manner as that of the example of the manufacturing step of the semiconductor device described in the first embodiment, description thereof is to be omitted.

### < Principal feature and effect of the embodiment >

In the fourth embodiment, since the carbon concentration is increased and the hydrophobic (water repellency) is improved at the surface of the tungsten film before coating of the resist for resist pattern formation, like the third embodiment, adhesion of the resist pattern at the surface of the tungsten film can be improved. Accordingly, exfoliation of the formed resist pattern from the tungsten film can be suppressed in any of the substrates for test exposure and the substrates for product production.

Further, in the fourth embodiment, like in the third embodiment, since the substrate is not coated with the resist for pretreatment as the pretreatment step and there is no requirement of performing the step of removing the coated resist for pretreatment, the number of steps can be saved and the amount of the chemical solution used can be decreased compared with the first embodiment. Further, the organic solvent mixed with the polymeric organic compound at an optimal mixing ratio in accordance with the line width of the mask pattern (mask size) can be prepared easily by controlling the mixing ratio of mixing the polymeric organic compound to the organic solvent, so that the amount of the polymeric organic compound to be used can be decreased.

Further, in the fourth embodiment, after determining the optimal exposure conditions by using the substrate for test exposure, the substrate for product production is exposed under the determined optimal exposure conditions in the fourth embodiment. Accordingly, electrodes or interconnects comprising the tungsten film can be fabricated at a higher profiling accuracy and the performance of the manufactured semiconductor device, for example, MEMS can be improved further compared with the third embodiment.

Preferably, an identical substrate and identical organic solvent mixed with an identical polymeric organic compound, and an identical resist for resist pattern formation are used in the step S41 to step S47 in Fig. 38 and in the step S31 to step S37 in Fig. 31 and other conditions than the exposure conditions (for example, number of rotation of the substrate, heat treatment condition, etc.) are made identical. Thus, optimal exposure conditions can be obtained more easily.

As described above, the inventions achieved by the present inventors have been described specifically with reference to the preferred embodiments thereof but it goes without saying that the present invention is not restricted to the embodiments but can be modified within a range not departing the gist thereof.

For example, in the first embodiment to the fourth embodiment, the step of forming the resist pattern has been described with reference to the example of applying them to the manufacturing step of the semiconductor device of forming an MEMS comprising, for example, the supersonic sensor. However, the present invention is not restricted to the example of applying to the manufacturing step of the semiconductor device of forming MEMS and is also applicable, for example, to the manufacturing step of the semiconductor device comprising LSI including various semiconductor devices such as MISFET (Metal Insulator Semiconductor Field Effect Transistor) in which electrodes or interconnects comprising a tungsten film are formed.

The present invention is useful when it is applied to the manufacturing method of the semiconductor device.

## Claims

1. A method of manufacturing a semiconductor device including the steps of:
(a) coating an organic solvent mixed with a polymeric organic compound to a first substrate having a first tungsten film formed on the surface thereof,
(b) coating a chemically amplified resist over the substrate after the step (a), and
(c) patterning the coated chemically amplified resist after the step (b) in which
a ratio of a C1s peak intensity to a W4d peak intensity measured by XPS at the surface of the first tungsten film is 0.1 or more after the step (a) and before the step (b).

2. A method of manufacturing a semiconductor device according to claim 1, wherein
the polymeric organic compound is a novolac resin.

3. A method of manufacturing a semiconductor device according to claim 1 or 2, wherein
the method further includes the steps of:
(d) coating the organic solvent mixed with the polymeric organic compound to a second substrate having a second tungsten film formed on the surface thereof,
(e) coating the chemically amplified resist to the second substrate after the step (d),
(f) exposing each of a plurality of regions of the second substrate under exposure conditions different from each other by using a mask pattern after the step (e),
(g) developing the second substrate after the step (f) thereby forming a first resist pattern over the second substrate, and
(h) determining optimal exposure conditions based on the shape of the first resist pattern formed in each of a plurality of regions of the second substrate after the step (b) in which the step (c) includes:
(i) exposing the first substrate under the determined optimal exposure conditions by using the mask pattern after the step (h),
(j) developing the first substrate after the step (i) thereby forming a second resist pattern over the first substrate, in which
the ratio of a C1s peak intensity to a W4d peak intensity measured by XPS is 0.1 or more at the surface of the second tungsten film after the step (d) and before the step (e).

4. A method of manufacturing a semiconductor device including the steps of:
(a) coating an organic solvent mixed with a polymeric organic compound over a first substrate having a first tungsten film formed on the surface thereof,
(b) coating a chemically amplified resist to the first substrate after the step (a), and
(c) patterning the coated chemically amplified resist after the step (b), in which
the angle of contact with water is 10 degree or more at the surface of the first tungsten film after the step (a) and before the step (b).

5. A method of manufacturing a semiconductor device according to claim 4, wherein
the polymeric organic compound is a novolac resin.

6. A method of manufacturing a semiconductor device according to claim 4 or 5, wherein the method further includes the steps of:
(d) coating the organic solvent mixed with the polymeric organic compound to a second substrate having a second tungsten film formed on the surface thereof,
(e) coating the chemically amplified resist to the second substrate after the step (d),
(f) exposing each of a plurality of regions of the second substrate under exposure conditions different from each other by using a mask pattern after the step (e),
(g) developing the second substrate after the step (f) thereby forming a first resist pattern over the second substrate, and
(h) determining optimal exposure conditions based on the shape of the first resist pattern formed in each of a plurality of regions of the second substrate after the step (b) in which the step (c) includes:
(i) exposing the first substrate under the determined optimal exposure conditions by using a mask pattern after the step (h),
(j) developing the first substrate after the step (i) thereby forming a second resist pattern over the first substrate, in which
the angle of contact with water is 10 degree or more at the surface of the second tungsten film after the step (d) and before step (e).

7. A method of manufacturing a semiconductor device including the step of:
(a) coating a first resist over a first substrate having a first tungsten film formed on the surface thereof,
(b) removing the coated first resist after the step (a),
(c) coating a second resist comprising a chemically amplified resist over the first substrate after the step (b) and
(d) patterning the coated second resist after the step (c).

8. A method of manufacturing a semiconductor device according to claim 7, wherein
a ratio of a C1s peak intensity to a W4d peak intensity measured by XPS is 0.1 or more at the surface of the first tungsten film after the step (b) and before the step (c).

9. A method of manufacturing a semiconductor device according to claim 7 or 8, wherein
an angle of contact with water is 10 degree or more at the surface of the first tungsten film after the step (b) and before the step (c).

10. A method of manufacturing a semiconductor device according to any of claims 7 to 9, wherein
(c) a step of heat treating the first substrate is included after the step (a) and before the step (b).

11. A method of manufacturing a semiconductor device according to any of claims 7 to 10, wherein
the method includes the steps of:
(f) coating the first layer over the second substrate having a second tungsten film formed on the surface thereof,
(g) supplying an organic solvent to the second substrate after the step (f) thereby removing the first resist,
(h) coating the second resist over the second substrate after the step (g),
(i) exposing each of a plurality of regions of the second substrate under exposure conditions different from each other by using a mask pattern after the step (h),
(j) developing the second substrate after the step (i) thereby forming a first resist pattern over the second substrate and
(k) determining optimal exposure conditions based on the shape of the first resist pattern formed in each of the plurality of regions in the second substrate after the step (j) in which the step (d) includes the steps of:
(1) exposing the first substrate under determined optimal conditions by using the mask pattern after the step (k) and
(m) forming a second resist pattern over the first substrate by developing the first substrate after the step (1),
wherein the organic solvent is supplied to the first substrate thereby removing the first resist in the step (b).

12. A method in accordance with any of the preceding claims, further comprising a feature from any other of the preceding claims.
